(19) Europäisches Patentamt
European Patent Office
Office européen des brevets

(11) EP 3 358 075 B1

(12) **EUROPEAN PATENT SPECIFICATION**

(45) Date of publication and mention of the grant of the patent:
**03.03.2021 Bulletin 2021/09**

(21) Application number: **16851749.8**

(22) Date of filing: **29.09.2016**

(51) Int Cl.:
***D21H 17/12*** *(2006.01)* ***B32B 5/02*** *(2006.01)*
***D21H 11/18*** *(2006.01)* ***D21H 11/20*** *(2006.01)*

(86) International application number:
**PCT/JP2016/078829**

(87) International publication number:
**WO 2017/057578 (06.04.2017 Gazette 2017/14)**

(54) **SHEET AND LAMINAT**

FOLIE UND LAMINAT

FEUILLE ET LAMINAT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2015 JP 2015193981**
**30.09.2015 JP 2015193982**

(43) Date of publication of application:
**08.08.2018 Bulletin 2018/32**

(73) Proprietor: **Oji Holdings Corporation**
**Chuo-ku**
**Tokyo 104-0061 (JP)**

(72) Inventors:
- **FUSHIMI Hayato**
**Tokyo 104-0061 (JP)**
- **BANZASHI Go**
**Tokyo 104-0061 (JP)**

(74) Representative: **Godemeyer Blum Lenze Patentanwälte**
**Partnerschaft mbB - werkpatent**
**An den Gärten 7**
**51491 Overath (DE)**

(56) References cited:
**EP-A1- 2 546 297**
**EP-A1- 2 998 435**
**JP-A- 2010 202 856**
**JP-A- 2012 021 081**
**JP-A- 2013 127 141**
**JP-A- 2013 245 259**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 358 075 B1

## Description

### Technical Field

The present invention relates to a sheet comprising ultrafine fibers and a laminate thereof.

### Background Art

In recent years, because of enhanced awareness of alternatives to petroleum resources and environmental consciousness, there has been a focus on materials utilizing reproducible natural fibers. Among natural fibers, cellulose fibers having a fiber diameter of 10 to 50 μm, in particular, wood-derived cellulose fibers (pulp) have been widely used mainly as paper products so far.

In addition, ultrafine cellulose fibers, which have a fiber diameter of 1 μm or less, are known as cellulose fibers. Since the contacts of fibers are significantly increased in a sheet or a complex containing ultrafine cellulose fibers, the tensile strength of such a sheet or a complex is significantly improved. In addition, since the fiber width becomes shorter than the wavelength of a visible light, the transparency is significantly improved. As a method of producing ultrafine fibers, a method of introducing a substituent having electrostatic or steric functionality into a fiber raw material in order to facilitate fibrillation (defibration) of the fiber raw material is known (for example, Patent Documents 1 to 4).

With regard to ultrafine fibers into which a substituent having functionality has been introduced, studies have been conducted from various viewpoints. For example, in Patent Document 5, taking into consideration the problem that when cellulose nanofibers having a carboxylic acid group are poured into the same organic solvent as that for materials to be conjugated, in order to conjugation of the nanofibers with the materials, they are agglutinated and precipitated, studies have been conducted from the viewpoint of providing cellulose nanofibers soluble in a wide range of organic solvents. Herein, specifically, an attempt has been made to substitute a carboxylate-type group to a carboxylate amine salt-type group having an organic group, and then to disperse it in an organic solvent. Moreover, in Patent Document 6, from the viewpoint of providing a dispersion comprising ultrafine cellulose fibers, which can be uniformly dispersed in an organic solvent or a resin and do not contain metal ions in order to retain water resistance and strength when they are processed into a sheet, there has been proposed an ultrafine cellulose fiber dispersion, which is characterized in that it comprises ultrafine cellulose fibers and ammonia or organic alkali. Furthermore, in Patent Document 7, a technique of producing a slurried dispersion with high efficiency, ensuring the stability of the dispersion even on the acidic side, and reducing the viscosity of the dispersion has been studied as an object. In this patent document, ultrafine cellulose fibers, into which two types of functional groups having a salt type with at least one selected from the group consisting of a cation, an ammonium ion, an aliphatic ammonium ion, and an aromatic ammonium ion have been introduced, are proposed.

### Prior Art Documents

#### Patent Documents

Patent Document 1: JP Patent Publication (Kokai) No. 2008-308802 A
Patent Document 2: JP Patent Publication (Kokai) No. 2010-254726 A
Patent Document 3: JP Patent Publication (Kohyo) No. 2012-511596 A
Patent Document 4: International Publication No. WO 2013/073652
Patent Document 5: JP Patent Publication (Kokai) No. 2012-21081 A
Patent Document 6: International Publication No. WO 2011/111612
Patent Document 7: JP Patent Publication (Kokai) No. 2013-253200 A

### Summary of Invention

#### Object to be Solved by the Invention

An object of the present invention is to provide an ultrafine fiber-containing sheet and a laminate, in which wrinkles and/or cracks generated upon sheet formation are suppressed.

Means for Solving the Object

As a result of intensive studies in order to achieve the above object, the present inventors found for the first time that intended effects can be obtained by appropriately adjusting the content of a counterion in a sheet, or by treating ultrafine fibers having a phosphoric acid-derived group with an organic onium ion, thereby completing the present invention.
The present invention provides the following.

[1] A sheet comprising

ultrafine fibers having an ionic substituent being at least one selected from the group consisting of a phosphoric acid-derived group, a carboxylic acid-derived group, and a sulfuric acid-derived group,
wherein the amount of ionic substituents is from 0.001 to 5.0 mmol/g,
wherein the ultrafine fibers are fibers having a fiber width of 1000 nm or less, and
an organic ion that is a counterion of the ionic substituent, wherein
the content of the organic ion is 0.40 mmol/g or less.

[2] The sheet according to [1], which has a haze of 40% or less.
[3] The sheet according to [1] or [2], which has a density of 1.0 g/$cm^3$ or more.
[4] The sheet according to any one of [1] to [3], wherein the organic ion contains 4 or more carbon atoms.
[5] The sheet according to any one of [1] to [4], wherein the content of the ionic substituent is 0.5 mmol/g or less based on the ultrafine fibers.
[6] The sheet according to any one of [1] to [5], which has an elastic modulus in tension of 4.0 GPa or more at a temperature of 23°C at a relative humidity of 50%.
[7] A laminate comprising
the sheet according to any one of [1] to [6], and
at least one of an inorganic layer and an organic layer formed at least one side of the sheet.

Advantageous Effects of Invention

In the ultrafine fibers having an ionic substituent obtained by the present invention, wrinkles and/or cracks generated upon sheet formation are suppressed.

Brief Description of Drawings

[Fig. 1] Fig. 1 shows three regions in the measurement of the content of a substituent by a conductometric titration method.

Embodiment of Carrying out the Invention

The value regarding the mass of fibers such as cellulose is based on the absolute dry mass (solid content), unless otherwise specified. The range "X to Y" includes both of the values X and Y, unless otherwise specified.
The present invention provides a sheet comprising ultrafine fibers having an ionic substituent, and an organic ion that is a counterion of the ionic substituent, wherein the content of the organic ion is a predetermined value or less, a laminate comprising the same, and a method for producing them.
According to the studies conducted by the present inventors, when hydrophilic functional group-introduced ultrafine fibers are dried to form a sheet, agglutination of the ultrafine fibers takes place due to the formation of a hydrogen bond, and thus, wrinkles and/or cracks are generated on the sheet under practical drying conditions, and thereby, the yield of sheets has tended to be decreased. Meanwhile, the present inventors have attempted to impart a counterion to the introduced functional group in order to prevent the formation of a hydrogen bond. However, while the yield has been improved, a reduction in the mechanical properties of a sheet has been concerned. An ultrafine fiber-containing sheet has been required to improve its strength, while suppressing wrinkles and/or cracks. However, a technique of achieving both of them has not been sufficiently studied so far. The present inventors have conducted intensive studies towards achieving both the suppression of wrinkles and/or cracks generated on a sheet and the improvement of strength. As a result, the inventors have found that intended effects can be obtained by appropriately adjusting the content of a counterion in a sheet. The sheet of the present invention is also advantageous in terms of excellent mechanical strength.

1. Sheet comprising ultrafine fibers and organic ion (organic onium ion, etc.)

[Ultrafine fibers having ionic substituent such as phosphoric acid-derived group]

< Ultrafine fibers >

The sheet of the present invention comprises ultrafine fibers having an ionic substituent.

Ultrafine fibers having an ionic substituent such as a phosphoric acid-derived group are obtained by introducing an ionic substituent into a fiber raw material, and then subjecting the raw material to a fibrillation treatment. In the present invention, ultrafine fibers are fibers having a fiber width of 1000 nm or less, and in particular, natural fibers are preferable. Such natural fibers are preferably polysaccharides because they are highly available, and are more preferably cellulose, chitin or chitosan, in order for a sheet formed from the fibers to have sufficient strength. The natural fibers are particularly preferably cellulose fibers. Hereafter, the present invention, the embodiments thereof, and the examples thereof will be explained by taking the case of using ultrafine cellulose fibers as an example. A person skilled in the art could appropriately apply the explanation to the case of using other types of fibers and could understand it.

The average fiber width of ultrafine fibers comprised in the sheet of the present invention is not particularly limited, as long as it is 1000 nm or less. The average fiber width can be, for example, 1 nm or more, preferably 2 to 1000 nm, more preferably 2 to 500 nm, and further preferably 3 to 100 nm. If the average fiber width of ultrafine fibers is 1000 nm or less, the characteristics of ultrafine fibers (high transparency, high modulus of elasticity, low linear expansion coefficient, and flexibility) are easily exhibited. On the other hand, if the average fiber width is 1 nm or more, dissolution of molecules in water is suppressed, and thus, physical properties of ultrafine fibers (strength, rigidity, and dimensional stability) are sufficiently expressed.

In intended use where a sheet is required to have relatively high transparency, if the average fiber width is 30 nm or less, it approaches to 1/10 of the wavelength of visible light, and when the sheet is processed into a laminate, refraction and scattering of visible light hardly take place at the interface, and thus, a highly transparent laminate tends to be obtained. As such, although the average fiber width is not particularly limited, it is preferably 2 to 30 nm, and more preferably 2 to 20 nm. Since a laminate obtained from such ultrafine fibers is generally a dense structure, it has sufficient strength, and since the scattering of visible light hardly takes place, the laminate has high transparency.

The measurement of the average fiber width is carried out as follows. A slurry containing ultrafine fibers of 0.05 to 0.1% by mass in concentration is prepared, and the prepared slurry is then cast on a carbon film-coated grid which has been subjected to a hydrophilic treatment to thereby make a sample for TEM observation. In the case where the slurry contains fibers having large widths, the SEM image of the surface of the slurry cast on a glass may be observed. The sample is observed by electron microscopy imaging at a magnification of 1000, 5000, 10000, 20000 or 50000, depending on the width of fibers constituting the sample. Provided that the sample, the observation condition and the magnification are adjusted so as to meet the following conditions.

(1) A single straight line X is drawn in any given portion in an observation image, and 20 or more fibers intersect with the straight line X.

(2) A straight line Y, which intersects perpendicularly with the aforementioned straight line in the same image as described above, is drawn, and 20 or more fibers intersect with the straight line Y.

The widths of the fibers intersecting the straight line X and the straight line Y in the observation image meeting the above-described conditions are visually read. 3 or more sets of images of surface portions, which are at least not overlapped, are thus observed, and the widths of the fibers intersecting the straight line X and the straight line Y are read in the each image. At least 120 fiber widths (20 fibers $\times$ 2 $\times$ 3 = 120) are thus read. The average fiber width is an average value of the fiber widths thus read.

The fiber length is not especially limited, but is preferably 0.1 $\mu$m or longer. A fiber length of 0.1 $\mu$m or longer is preferred in that when a sheet described later is produced, the tear strength of the sheet is sufficient. The fiber length can be determined by image analysis of TEM, SEM and AFM. The above fiber length is a fiber length of fibers accounting for 30% by mass or more in the ultrafine fibers.

The axial ratio (fiber length/fiber width) of the fibers is not especially limited, but is preferably in the range of 20 to 10000. An axial ratio of 20 or higher is preferred in that an ultrafine fiber-containing sheet is easy to form. An axial ratio of 10000 or lower is preferred in that the slurry viscosity becomes low.

< Ionic substituent such as phosphoric acid-derived group >

Ultrafine fibers comprised in the sheet of the present invention have an ionic substituent. Such an ionic substituent facilitates the fibrillation (defibration) of a fiber raw material in the production of an ultrafine fiber-containing sheet.

The ionic substituent is an anionic substituent.

Examples of the anionic substituent include a phosphoric acid group or a phosphoric acid group-derived substituent (hereinafter such a phosphoric acid group and a phosphoric acid group-derived substituent are also referred to as a phosphoric acid-derived group), a carboxy group or a carboxy group-derived substituent (hereinafter such a carboxy group and a carboxy group-derived substituent are also referred to as a carboxylic acid-derived group), a sulfuric acid group or a sulfuric acid group-derived substituent (hereinafter such a sulfuric acid group and a sulfuric acid group-derived substituent are also referred to as a sulfuric acid-derived group), and a sulfonic acid group or a sulfonic acid group-derived substituent (hereinafter such a sulfonic acid group and a sulfonic acid group-derived substituent are also referred to as a sulfonic acid-derived group). The phosphoric acid group is a divalent functional group, which corresponds to phosphoric acid from which a hydroxyl group is removed. Specifically, it is a group represented by $-PO_3H_2$. Examples of the phosphoric acid group-derived substituent include substituents such as a polycondensated phosphoric acid group, the salt of a phosphoric acid group, or a phosphoric acid ester group. In addition, the phosphoric acid group or the phosphoric acid group-derived substituent may be represented by the following formula (1).

[Formula 1]

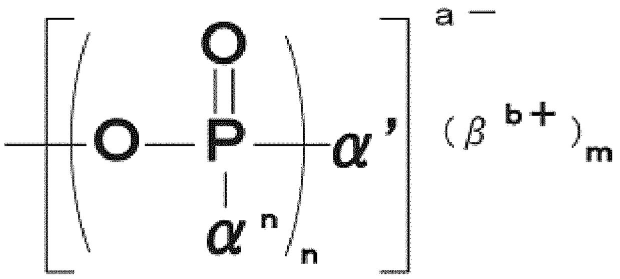

(1)

In the formula (1), a, b, m and n each independently represent an integer (provided that a = b x m); $\alpha^n$ (wherein n is an integer of 1 to n) and α' each independently represent R or OR. R represents a hydrogen atom, a saturated linear hydrocarbon group, a saturated branched hydrocarbon group, a saturated cyclic hydrocarbon group, an unsaturated linear hydrocarbon group, an unsaturated branched hydrocarbon group, an aromatic group, or a derivative group thereof; and β represents a mono- or poly-valent cation consisting of an organic matter or an inorganic matter.

In the present invention, from the viewpoint of easy handleability and reactivity with fibers upon production, the anionic substituent is preferably at least one selected from the group consisting of a phosphoric acid-derived group, a carboxylic acid-derived group, and a sulfuric acid-derived group. These groups more preferably form an ester or ether with fibers, but it is not particularly limited.

In a preferred aspect of the present invention, in order to reduce organic ions contained in the sheet, a method of eliminating the organic ions together with the ionic substituents is adopted, as described later. In this case, the content of the ionic substituent in the sheet is not particularly limited, as long as the sheet has the intended characteristics. The content of the ionic substituent in the sheet is preferably 0.5 mmol/g or less, more preferably 0.1 mmol/g or less, and further preferably 0.05 mmol/g or less, with respect to the sheet or ultrafine fibers. If the content of the ionic substituent is 0.5 mmol/g or less, it is considered that organic ions are sufficiently reduced. The lower limit value of the content of the ionic substituent is not particularly limited. Regardless of the upper limit value of the content of the ionic substituent, the lower limit value thereof is 0.001 mmol/g or more with respect to the sheet or ultrafine fibers. From the viewpoint of a reduction in organic ions that are concerned about influence on sheet strength, it is considered that the content of the ionic substituent in the sheet is preferably set as low as possible.

The content (mmol/g) of the ionic substituent in the sheet can be measured as follows, using an X-ray fluorescence analysis method.

First, as a sheet used in production of a calibration curve, a sheet comprising the same ultrafine fibers as those used in a measurement target sheet, in which the content (mmol/g) of the ionic substituent has been known, is prepared, and the X-ray intensity of this sample is measured by X-ray fluorescence analysis. The measured element is an element that is comprised in the ionic substituent but is not comprised in the ultrafine fibers (for example, when the ionic substituent is a phosphoric acid-derived group, the element is a phosphorus atom), or an element that is comprised in a counterion of the ionic substituent but is not comprised in the ultrafine fibers. As necessary, the counterion of the ionic substituent in the measurement target sheet is exchanged with another counterion containing an element that is not comprised in the ultrafine fibers, and then, the measurement target sheet can be subjected to measurement. For example, when the ionic substituent is a carboxylic acid-derived group, the counterion is exchanged with a sodium ion, and thereafter, the

measurement target sheet can be subjected to the measurement. In this case, the measured element is a sodium ion. Subsequently, a calibration curve is produced based on the thus obtained X-ray intensity and the known content of the ionic substituent.

Meanwhile, the X-ray intensity of the measurement target sheet is measured by X-ray fluorescence analysis. Subsequently, from the thus obtained X-ray intensity and the above-described calibration curve, the content (mmol/g) of the ionic substituent in the measurement target sheet is obtained. The obtained value can be indicated as the content of the ionic substituent in the sheet or ultrafine fibers.

In the sheet of the present invention, when a method that does not involve elimination of the ionic substituent is adopted upon the removal of the counterion, the content of the ionic substituent in the sheet corresponds to the amount of the ionic substituent introduced into the sheet upon the production thereof. When the introduced substituent is at least one selected from the group consisting of a phosphoric acid-derived group, a carboxylic acid-derived group, and a sulfuric acid-derived group, the amount of the introduced substituent is not particularly limited, and it can be set at 0.001 to 5.0 mmol/g. The amount of the introduced substituent may be set at 0.05 to 4.0 mmol/g, or may also be set at 0.1 to 2.0 mmol/g.

[Organic ion]

The sheet of the present invention comprises an organic ion. The organic ion means an ion, which is capable of forming an ion pair with an ionic substituent possessed by fibers and has an organic group. The organic group means a group derived from an organic compound (a compound having a carbon atom). Such an organic ion suppresses the formation of a hydrogen bond between ionic substituents in a drying step upon the formation of a sheet from ultrafine fibers having such ionic substituents, so that it can suppress generation of wrinkles and/or cracks on the sheet. Conventionally, there have been an organic ion that converts a carboxy group on a fiber to an amine salt-type group (the aforementioned Patent Document 5), an organic ion that converts a carboxy group on a fiber to an onium salt-type group (the aforementioned Patent Document 6), and an organic ion that converts a carboxy group and a phosphoric acid group on a fiber to ammonium salt-type groups. All of these have been used to improve dispersibility in an organic solvent and to ensure compatibility with a resin as a target of conjugation. The present inventors have focused on a novel object that is suppression of wrinkles and/or cracks generated upon the formation of a sheet from ultrafine fibers, and have used, for the first time, an organic ion in an ultrafine fiber-containing sheet having an ionic substituent in the present invention.

< Type of organic ion such as organic onium ion >

In the sheet of the present invention, the type of the organic ion when ultrafine fibers have an anionic substituent are not particularly limited, as long as desired effects are exhibited. When ultrafine fibers have an anionic substituent, the organic ion is preferably an organic onium ion represented by the following formula (2).

[Formula 2]

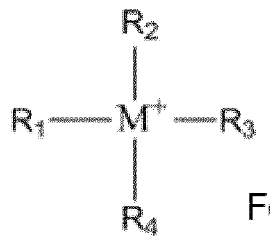

Formula (2)

wherein

M represents a nitrogen atom or a phosphorus atom;

at least one of $R_1$ to $R_4$ represents an organic group optionally containing a heteroatom, and the others are hydrogen atoms. The number of carbon atoms contained in the organic group (which is a total number of carbon atoms, when the organic onium ion has a plurality of organic groups) is 1 or more, and it is not particularly limited as long as desired effects are exhibited. The number of carbon atoms is preferably 4 or more, more preferably 8 or more, and further preferably 16 or more. This is because an organic onium ion, which has a large number of carbon atoms and is relatively highly bulky, has great effects. $R_1$ to $R_4$ may be identical to or different from one another. However, preferably, $R_1$ to $R_4$ are the same groups as one another, or are groups having almost the same size. This is because spherical groups are considered to have higher effects than linear groups.

Such an organic onium ion is preferably, for example, a tetraalkylonium ion, and more preferably comprises at least one of a tetraalkylammonium ion and a tetraalkylphosphonium ion. Examples of such a tetraalkylammonium ion include a tetramethylammonium ion, a tetraethylammonium ion, a tetrapropylammonium ion, a tetrabutylammonium ion, a tetrapentylammonium ion, a tetrahexylammonium ion, a tetraheptylammonium ion, a tributylmethylammonium ion, a lauryltrimethylammonium ion, a cetyltrimethylammonium ion, a stearyltrimethylammonium ion, an octyldimethylethylammonium ion, a lauryldimethylethylammonium ion, a didecyldimethylammonium ion, a lauryldimethylbenzylammonium ion, and a tributylbenzylammonium ion. Examples of such a tetraalkylphosphonium ion include a tetramethylphosphonium ion, a tetraethylphosphonium ion, a tetrapropylphosphonium ion, a tetrabutylphosphonium ion, and a lauryltrimethylphosphonium ion. Besides, as a tetrapropylonium ion and as a tetrabutylonium ion, a tetra-n-propylonium ion and a tetra-n-butylonium ion are particularly preferably used, respectively.

< Content of organic ion such as organic onium ion >

The sheet of the present invention comprises an organic ion. The content of the organic ion in the sheet is 0.40 mmol/g or less. The organic ion has been added to the ionic substituent before the formation of a sheet, and then, after completion of the sheet formation, the content of the organic ion is reduced to 0.40 mmol/g or less. As a result of a reduction in the content of the organic ion, the mechanical strength of the sheet can be increased. From the viewpoint of further improving mechanical strength, the content of the organic ion in the sheet is preferably 0.20 mmol/g or less, more preferably 0.10 mmol/g or less, and further preferably 0.05 mmol/g or less. On the other hand, the lower limit value of the content of the organic ion in the sheet is not particularly limited, and the lower limit value can be set at 0 mmol/g with respect to the sheet. For example, the lower limit value may be, for example, 0.005 mmol/g. It is to be noted that, when the phrase "the content of the organic ion" is used with regard to fibers or a sheet in the present invention, the content of the organic ion indicates a value obtained by the after-mentioned measurement method, regardless of whether the organic ion forms an ion pair with the ionic substituent on the sheet, unless otherwise specified.

The content (mmol/g) of the organic ion in the sheet can be measured, for example, by applying a chemiluminescence method, infrared spectroscopy, time-of-flight mass spectrometry, an X-ray fluorescence analysis method, etc.

In addition, when the organic ion contains nitrogen, the nitrogen atom concentration in the sheet can also be measured, for example, by using a trace nitrogen analysis device according to a chemiluminescence method. At this time, the nitrogen atom concentration of an ultrafine fiber-containing sheet that has not been treated with an organic ion is also measured, and the obtained value is subtracted from the nitrogen atom concentration of the ultrafine fiber-containing sheet as a measurement target to obtain the concentration of an organic ion-derived nitrogen atom, so that the content of the organic ion can be calculated. It is considered that, when ultrafine fibers comprise, for example, a phosphoric acid-derived group as an ionic substituent, the fibers are treated by the after-mentioned polyhydric alcohol boiling method under the use of glycerin at 180°C for 2 hours, so that the resulting fibers can be handled in the same manner as that for an ultrafine fiber-containing sheet to which an organic ion has not been imparted. When the sheet comprises an ionic substituent other than the phosphoric acid-derived group, in the after-mentioned counterion exchange, if the ionic substituent is an anionic substituent, the sheet is immersed in a treatment solution with pH 1 for 2 hours, so that the resulting sheet can be handled in the same manner as that for an ultrafine fiber-containing sheet to which an organic ion has not been imparted.

When the organic ion contains a phosphorus atom, the concentration of a phosphorus atom derived from the organic ion in the sheet can be calculated as follows, for example, by applying an X-ray fluorescence analysis method. First, X-ray fluorescence analysis is performed on a sheet as a measurement target, and thereafter, based on the previously prepared calibration curve of the characteristic X-ray intensity of a phosphorus atom and the introduced amount of phosphorus, the concentration of a phosphorus atom in the measurement target sheet is calculated. Subsequently, the concentration of a phosphorus atom in an ultrafine fiber-containing sheet containing no organic ions is also measured, and the obtained value is subtracted from the concentration of a phosphorus atom in the ultrafine fiber-containing sheet as a measurement target to obtain the concentration of an organic ion-derived phosphorus atom, so that the content of the organic ion can be calculated. In the case of an ultrafine fiber-containing sheet containing no organic ions, in the after-mentioned counterion exchange, for example, when the sheet as a measurement target contains an anionic substituent, it is immersed in a treatment solution with pH 1 for 2 hours, so that the resulting sheet can be handled in the same manner as that for an ultrafine fiber-containing sheet to which an organic ion has not been imparted.

When the organic ion such as an organic onium ion contains an element other than nitrogen, which is not present in the ultrafine fiber-containing sheet, the content of the organic ion such as an organic onium ion in the sheet can be measured as follows, by applying an X-ray fluorescence analysis method.

First, a sample having a composition and a form similar to those of a measurement target sheet (for example, a filter is used), in which the content (mmol/g) of an analytical element has been known, is prepared for use in production of a calibration curve, and the X-ray intensity of the sample is then measured by X-ray fluorescence analysis. Herein, the element, which is contained in an organic ion such as an organic onium ion but is not considered to be present in

an ultrafine fiber-containing sheet, is used as an analytical element. Based on the thus obtained X-ray intensity and the known content of the analytical element, a calibration curve is produced. Subsequently, according to X-ray fluorescence analysis, the X-ray intensity of the measurement target sheet is measured. Then, based on the thus obtained X-ray intensity and the above-described calibration curve, the content (mmol/g) of the analytical element in the measurement target sheet is calculated.

[Characteristics of sheet]

The sheet of the present invention has the following characteristics.

< Density >

The density of a sheet means a value (g/$cm^3$) obtained from the thickness and mass of a sheet with a 100-mm square, which has been subjected to humidity control under conditions of a temperature of 23°C and a relative humidity of 50% for 24 hours. The density of the sheet of the present invention can be appropriately determined depending on intended use and the like. From the viewpoint of strength and transparency, the density of the present sheet can be set at 0.1 to 7.0 g/$cm^3$, and it is preferably 0.5 to 5.0 g/$cm^3$, and more preferably 1.0 to 3.0 g/$cm^3$.

< Wrinkles and/or cracks >

Wrinkles and/or cracks generated upon the production of a sheet can be evaluated by the following method. That is, when a dispersion of ultrafine fibers is subjected to sheet formation, a total of 81 squares (9 squares in depth x 9 squares in width) are written on the back of an acrylic plate, such that they can fit to the size of a damming metallic mold with a 180-mm square. An ultrafine fiber-containing sheet, which is attached to the acrylic plate, is observed from above, and squares, in which wrinkles and/or cracks are generated, are counted. Subsequently, the percentage of the squares, in which wrinkles and/or cracks are generated, to the total square number is calculated.
In the case of the sheet of the present invention, the percentage of the squares, in which wrinkles and/or cracks are generated, is less than 20%, when it is evaluated by this method.

< Total light transmittance >

The total light transmittance of a sheet means a value measured using a hazemeter in accordance with JIS K7361. The sheet of the present invention has high transparency, and the total light transmittance thereof is 80% or more, preferably 85% or more, and more preferably 88% or more.

< Haze value >

The haze value of a sheet means a value measured using a hazemeter in accordance with JIS K7136. The sheet of the present invention has high transparency, and the haze value thereof is 40.0% or less, preferably 35.0% or less, and more preferably 20.0% or less.

< Tensile strength and elastic modulus in tension >

The tensile strength and elastic modulus in tension of a sheet mean values measured at a temperature of 23°C at a relative humidity of 50% using a tension testing machine in accordance with JIS K7127.
In respect with the sheet of the present invention, generation of wrinkles and/or cracks is suppressed upon the production thereof, and the sheet of the present invention is excellent in terms of tensile strength and elastic modulus in tension, in comparison to a sheet in which an organic ion is not used with respect to an ionic substituent. Specifically, the tensile strength of the sheet of the present invention is preferably 60.0 MPa or more, more preferably 70.0 MPa or more, and further preferably 80.0 MPa or more. This is because if the tensile strength is the aforementioned value or greater, the sheet endures the use as an optical material. The upper limit value is not particularly limited, and it is, for example, 400.0 MPa or less, or 300.0 MPa or less.
On the other hand, the elastic modulus in tension of the sheet of the present invention is preferably 4.0 GPa or more, more preferably 5.0 GPa or more, and further preferably 6.5 GPa or more. This is because if the elastic modulus in tension is the aforementioned value or greater, the sheet endures the use as an optical material. The upper limit value is not particularly limited, and it is, for example, 25.0 GPa or less, or 20.0 GPa or less.
It is considered that generation of wrinkles and/or cracks is suppressed upon the production of the sheet of the present invention and the present sheet is excellent in terms of tensile characteristics for the following factors. Upon the

formation of the sheet, an appropriate organic ion is added as a counterion to an ionic substituent (whereby agglutination of ultrafine fibers due to the ionic substituent, which is observed in a drying step upon sheet formation, can be prevented), and after completion of the sheet formation, the organic ion that may affect the strength of the sheet is reduced to a suitable extent.

According to the present inventors, it is assumed that appropriate selection of conditions for producing ultrafine fibers, the type of the ionic substituent on the ultrafine fibers, optionally the amount of the ionic substituent, the type of the organic ion comprised in the sheet, optionally the amount of the organic ion, etc. would contribute to the improvement of tensile characteristics, as well as suppression of wrinkles and/or cracks. These conditions are considered to have influence on the density, total light transmittance, haze, yellowness change, and the like of the sheet.

< Yellowness change >

The yellowness change ($\Delta YI$) of a sheet is represented by the following formula:

$$\Delta YI = YI_2 - YI_1$$

In the above formula, $YI_1$ indicates yellowness before performing vacuum drying at 200°C for 4 hours, and $YI_2$ indicates yellowness after performing vacuum drying at 200°C for 4 hours. Yellowness means a value measured in accordance with JIS K7373.

In the sheet of the present invention, yellowness change ($\Delta YI$) is suppressed. The yellowness change ($\Delta YI$) of the sheet of the present invention is, for example, 75.0 or less.

Upon the formation of the sheet, an appropriate organic onium ion is added as a counterion to a phosphoric acid-derived group (whereby agglutination of ultrafine fibers due to the phosphoric acid-derived group, which is observed in a drying step upon sheet formation, can be prevented). In addition, the type of a group on ultrafine fibers, optionally the amount thereof, the type of an organic onium ion comprised in the sheet, and optionally the amount thereof are appropriately selected. Thus, it is assumed that appropriate selection of conditions for producing ultrafine fibers or a sheet comprising the ultrafine fibers would contribute to the imparting of flexibility and suppression of yellowing caused by heating. Moreover, it is considered that these conditions have influence on the density, total light transmittance, haze, yellowness change, and the like of the sheet.

In a preferred aspect, upon a reduction in organic ions comprised in the sheet, a method of eliminating the organic ions together with the ionic substituents is adopted, as described later. In this case, the yellowness change ($\Delta YI$) is 50.0 or less, more preferably 7.0 or less, and further preferably 5.0 or less. In a preferred aspect, the reason for suppression of the yellowness change is that the yellowing of the sheet caused by heating is further suppressed by elimination of organic ions or ionic substituents. In addition, this is also because, when the ionic substituent is a phosphoric acid-derived group, if a reduction in the organic ions is achieved by eliminating them together with the phosphoric acid-derived groups, char formation under high temperature conditions, caused by the phosphoric acid-derived groups, is also reduced.

< Pencil hardness >

Pencil hardness means a value measured in accordance with JIS K5600. The load applied to a sample is set at 500 g.

< Molding followability >

Molding flexibility can be evaluated by the following method. That is, an ultrafine fiber-containing sheet is cut into a 150-mm square, and a cylindrical molded body made of wood, having a diameter of 50 mm and a height of 60 mm, is entirely wrapped with the aforementioned cut sheet. Subsequently, the cylindrical molded body is observed from above by eyes. Such visual observation is carried out from the viewpoint of the presence or absence of a void between the cylindrical molded body and the sheet, and cracks generated on the sheet.

2. Method for producing sheet

A method for producing the sheet of the present invention comprises

(1) a step of introducing an ionic substituent into a fiber raw material to obtain ionic substituent-introduced fibers, and

(2) a step of subjecting the ionic substituent-introduced fibers to a fibrillation treatment to obtain ionic substituent-introduced ultrafine fibers, and before or after the step (2), the production method further comprises

- a step of treating the ionic substituent with an organic ion, and then, the production method further comprises

(3) a step of preparing a sheet from the ionic substituent-introduced ultrafine fibers that have been treated with the organic ion, and
(4) a step of reducing the organic ion comprised in the sheet.

[Step (1): step of introducing ionic substituent into fiber raw material to obtain ionic substituent-introduced fibers]

< Fiber raw material >

Ultrafine fibers having an ionic substituent are obtained by introducing an ionic substituent into a fiber raw material and then subjecting the fiber raw material to a fibrillation treatment. The fiber raw material used in the step (1) is highly available natural fibers, preferably cellulose, chitin or chitosan, and more preferably cellulose. From the viewpoint of availability and inexpensiveness, as such a fiber raw material, a pulp is preferably used. From the viewpoint of availability, a wood pulp containing cellulose is preferable among such pulps. Among wood pulps, since a chemical pulp contains a high rate of cellulose, the yield of ultrafine cellulose fibers becomes high upon fibrillation, and also, decomposition of cellulose in the pulp is low, and long-filament ultrafine cellulose fibers having a large axial ratio can be obtained. Thus, a chemical pulp is preferable, but the type of the pulp is not particularly limited thereto. Among others, a craft pulp and a sulfite pulp are most preferably selected, but the type of the pulp is not particularly limited thereto.

< Introduction of ionic substituent >

An ionic substituent is introduced into a fiber raw material. A method of introducing a substituent into fibers is not particularly limited. In respect with the sheet of the present invention, examples of the substituent-introducing method include an oxidation treatment and a treatment using a compound capable of forming a covalent bond with a functional group in fibers. The oxidation treatment is a treatment of converting a hydroxy group in fibers to an aldehyde group or a carboxy group, and examples of the oxidation treatment include a TEMPO oxidation treatment and a treatment using various types of oxidizing agents (sodium chlorite, ozone, etc.).
An example of the oxidation treatment can be the method described in Biomacromolecules 8, 2485-2491, 2007 (Saito et al.), but the type of the oxidation treatment is not particularly limited thereto.
The treatment using a compound capable of forming a covalent bond with a functional group in fibers can be carried out by mixing a compound reacting with a fiber raw material into the fiber raw material that is in a dry state or in a wet state, so as to introduce the above-described substituent into the fiber raw material. In order to promote the reaction upon the introduction of a substituent, a heating method is particularly effective. The heat treatment temperature applied upon introduction of a substituent is not particularly limited, and it is preferably a temperature range in which the thermolysis, hydrolysis, etc. of the fiber raw material hardly occur. For example, from the viewpoint of the thermolysis temperature of fibers, the heating temperature is preferably 250°C or lower, and from the viewpoint of suppression of the hydrolysis of fibers, it is preferably to carry out the heat treatment at a temperature from 100°C to 170°C.
The compound reacting with the fiber raw material is able to obtain ultrafine fibers and is able to introduce an ionic substituent.
When a compound having a phosphoric acid-derived group is used as a compound reacting with the fiber raw material, the type of the compound is not particularly limited. The compound is at least one selected from the group consisting of phosphoric acid, polyphosphoric acid, phosphorous acid, phosphonic acid, polyphosphonic acid, and a salt or an ester thereof. Among these, a compound having a phosphoric acid-derived group is preferable because of low costs, easy handleability, and that the efficiency of fibrillation (defibration) can be further improved by introduction of such a phosphoric acid-derived group into the fiber raw material. However, the type of the compound is not particularly limited thereto.
The compound having a phosphoric acid-derived group is not particularly limited. Examples of the compound having a phosphoric acid-derived group include phosphoric acid, and lithium salts of phosphoric acid, such as lithium dihydrogen phosphate, dilithium hydrogen phosphate, trilithium phosphate, lithium pyrophosphate, and lithium polyphosphate. More examples include sodium salts of phosphoric acid, such as sodium dihydrogen phosphate, disodium hydrogen phosphate, trisodium phosphate, sodium pyrophosphate, or sodium polyphosphate. Further examples include potassium salts of phosphoric acid, such as potassium dihydrogen phosphate, dipotassium hydrogen phosphate, tripotassium phosphate, potassium pyrophosphate, or potassium polyphosphate. Further examples include ammonium salts of phosphoric acid, such as ammonium dihydrogen phosphate, diammonium hydrogen phosphate, triammonium phosphate, ammonium pyrophosphate, or ammonium polyphosphate.

From the viewpoint of high efficiency of introduction of a phosphoric acid-derived group and industrial applicability, among these substances, phosphoric acid, sodium salts of phosphoric acid, potassium salts of phosphoric acid, and ammonium salts of phosphoric acid are preferable, and sodium dihydrogen phosphate and disodium hydrogen phosphate are more preferable. However, the compound having a phosphoric acid-derived group is not particularly limited thereto.

Moreover, from the viewpoint of reaction uniformity and high efficiency of introduction of a phosphoric acid-derived group, the compound is preferably used in the form of an aqueous solution, but the form of the compound is not particularly limited thereto. The pH of the aqueous solution of the compound is not particularly limited. From the viewpoint of high efficiency of introduction of a phosphoric acid-derived group, the pH is 17 preferably 7 or less. From the viewpoint of suppression of the hydrolysis of fibers, the pH is more preferably 3 to 7, but it is not particularly limited thereto.

In a preferred aspect of the production of the sheet of the present invention, for example, a compound having a phosphoric acid-derived group, together with at least one selected from among urea, thiourea, biuret, phenyl urea, benzyl urea, dimethyl urea, diethyl urea, tetramethyl urea, benzoylene urea, hydantoin and the like, is allowed to react with a fiber raw material.

When a compound having a carboxylic acid-derived group is used as a compound reacting with a fiber raw material, the compound is at least one selected from the group consisting of a compound having a carboxylic acid-derived group, an acid anhydride of the compound having a carboxylic acid-derived group, and a derivative thereof, although it is not particularly limited thereto.

Examples of the compound having a carboxylic acid-derived group include, but are not particularly limited to, dicarboxylic acid compounds such as maleic acid, succinic acid, phthalic acid, fumaric acid, glutaric acid, adipic acid or itaconic acid, and tricarboxylic acid compounds such as citric acid or aconitic acid.

Examples of the acid anhydride of the compound having a carboxylic acid-derived group include, but are not particularly limited to, acid anhydrides of dicarboxylic acid compounds, such as maleic anhydride, succinic anhydride, phthalic anhydride, glutaric anhydride, adipic anhydride, or itaconic anhydride.

Examples of the derivative of the compound having a carboxylic acid-derived group include, but are not particularly limited to, an imidized product of the acid anhydride of the compound having a carboxylic acid-derived group and a derivative of the acid anhydride of the compound having a carboxylic acid-derived group. Examples of the imidized product of the acid anhydride of the compound having a carboxylic acid-derived group include, but are not particularly limited to, imidized products of dicarboxylic acid compounds, such as maleimide, succinimide, or phthalimide.

The derivative of the acid anhydride of the compound having a carboxylic acid-derived group is not particularly limited. Examples include acid anhydrides of the compounds having a carboxylic acid-derived group, in which at least some hydrogen atoms are substituted with substituents (for example, an alkyl group, a phenyl group, etc.), such as dimethylmaleic anhydride, diethylmaleic anhydride, or diphenylmaleic anhydride.

Among the above-described compounds having a carboxylic acid-derived group, maleic anhydride, succinic anhydride and phthalic anhydride are preferable because these compounds are easily industrially applicable and are easily gasified, but the compounds are not particularly limited thereto.

When a compound having a sulfuric acid-derived group is used as a compound reacting with a fiber raw material, the compound is at least one selected from the group consisting of sulfuric anhydride, sulfuric acid, and a salt and an ester thereof, although it is not particularly limited thereto. From the viewpoint of low costs and that the efficiency of fibrillation (defibration) can be further improved by introduction of such a sulfuric acid group into the fiber raw material, among the aforementioned compounds, sulfuric acid is preferable, but the compound having a sulfuric acid-derived group is not particularly limited thereto.

By introduction of the substituent into the fiber raw material, the dispersibility of fibers in a solution is improved, so that fibrillation (defibration) efficiency can be enhanced.

The amount of the ionic substituent introduced is not particularly limited, as long as sufficient fibrillation is carried out. As described later, taking into consideration the amount of the substituent introduced into the sheet (or the content of di- or more valent metal and the amount of the substituent introduced), the amount of the ionic substituent introduced can be determined. When the sheet of the present invention comprises ultrafine fibers having an anionic substituent, the amount of the ionic substituent introduced (measured according to a titration method) is preferably $0.005\alpha$ to $0.11\alpha$, and more preferably $0.01\alpha$ to $0.08\alpha$, per g (mass) of fibers. If the amount of the ionic substituent introduced is $0.005\alpha$ or more, the fibrillation (defibration) of the fiber raw material becomes easy. On the other hand, if the amount of the ionic substituent introduced is $0.11\alpha$ or less, dissolution of fibers can be suppressed. Herein, $\alpha$ indicates the amount of a functional group with which a compound reacting with a fiber material can react, such as a hydroxy group or an amino group, which is comprised in 1 g of the fiber material (unit: mmol/g).

Besides, the amount of the substituent introduced into the surface of a fiber can be measured by the following method (titration method), unless otherwise specified.

Ultrafine fiber-containing slurry comprising approximately 0.04 g (absolute dry mass) of a solid content is

fractionated, and it is then diluted with ion exchange water to approximately 50 g. Then, while stirring the obtained solution, a 0.01 N sodium hydroxide aqueous solution is added dropwise thereto, and a change in the electrical conductivity value is then measured. The amount of the 0.01 N sodium hydroxide aqueous solution added dropwise at the time when the aforementioned value becomes minimum is defined as the amount added dropwise at the end point of titration. The substituent content X on the surface of cellulose is represented by X (mmol/g) = 0.01 (mol/l) x V (ml)/W (g). Herein, V: the amount of a 0.01 N sodium hydroxide aqueous solution added dropwise (ml), and W: a solid content (g) comprised in the ultrafine cellulose fiber-containing slurry.

When the introduced substituent is at least one selected from the group consisting of a phosphoric acid-derived group, a carboxylic acid-derived group, and a sulfuric acid-derived group, the amount of the substituent introduced is 0.001 to 5.0 mmol/g. The amount of the substituent introduced may be set at 0.05 to 4.0 mmol/g, or may also be set at 0.1 to 2.0 mmol/g.

< Acid treatment >

In the production of the sheet of the present invention, as necessary, an acid treatment can be carried out on fibers having an anionic substituent, after the step of introducing an ionic substituent into a fiber raw material to obtain ionic substituent-introduced fibers, and before the step of treating the ionic substituent with an organic ion.

The acid used in the acid treatment is preferably an acid having the degree of ionization that is higher than that of the introduced anionic substituent, but it is not particularly limited. The acid treatment can be carried out, for example, using one or two or more selected from the group consisting of hydrochloric acid, nitric acid and sulfuric acid. By performing such a treatment, the introduced ionic substituent is sufficiently converted to an H-type substituent, so that an organic ion such as an organic onium ion can be easily added to the ionic substituent.

The method of performing the acid treatment can be carried out by immersing ionic substituent-introduced fibers in an acid solution. As a solvent used in such an acid solution, at least one of water and an organic solvent can be used. A solvent having polarity (a polar organic solvent such as water or alcohol) is preferable, and an aqueous solvent comprising water is more preferable. A particularly preferred example of the acid solution is hydrochloric acid.

In the acid treatment, the pH at 25°C of an acid solution can be set as appropriate. The pH is preferably 4 or less, more preferably 3.5 or less, and further preferably 3 or less.

In order to decrease the amount of an acid used, fibers having an ionic substituent may be washed before the acid treatment treatment step. At least one of water and an organic solvent can be used in the washing. Also, after completion of the acid treatment, the treated fibers having an ionic substituent may be washed with at least one of water and an organic solvent. The washing operation can be carried out repeatedly.

[Step (2): Step of subjecting ionic substituent-introduced fibers to fibrillation treatment to obtain ionic substituent-introduced ultrafine fibers]

For the fibrillation (defibration) treatment, fibers are dispersed in a solvent. The type of the solvent is not particularly limited, as long as the fibrillation (also referred to as defibration) treatment is appropriately carried out therein. An aqueous solvent (water or a mixture of water and an organic solvent) can be used. Examples of the organic solvent include alcohols such as methanol, ethanol, n-propanol, isopropanol, n-butanol, and t-butyl alcohol. Further examples thereof include: ketones such as acetone and methyl ethyl ketone (MEK); ethers such as diethyl ether and tetrahydrofuran (THF); and dimethyl sulfoxide (DMSO), dimethylformamide (DMF), and dimethylacetamide (DMAc). One of these organic solvents may be used, or two or more thereof may also be used.

The dispersion concentration is preferably 0.1% to 20% by mass, and more preferably 0.5% to 10% by mass. This is because when the content is equal to or higher than the above-described lower limit value, the efficiency of the treatment is improved; and when the content is equal to or lower than the above-described upper limit value, clogging in the defibration treatment apparatus can be prevented.

The defibration treatment apparatus is not particularly limited. Examples thereof include a high-speed defibrillator, a grinder (stone mill-type crusher), a high-pressure homogenizer, an ultrahigh-pressure homogenizer, Clearmix, a high-pressure collision-type crusher, a ball mill, a bead mill, a disc-type refiner, and a conical refiner. Also, a wet milling apparatus such a twin-screw kneader, an oscillation mill, a homomixer under high-speed rotation, an ultrasonic disperser, or a beater can be appropriately used.

The fibrillation treatment is carried out until fibers with a desired average fiber diameter can be obtained. According to the fibrillation treatment, a dispersion of ultrafine fibers (slurry) is obtained. The obtained dispersion of ultrafine fibers may comprise fibers having a fiber width of more than 1000 nm, but the dispersion preferably does not comprise fibers having a fiber width of more than 1000 nm. The concentration of the ultrafine fibers used herein can be, for example, 0.1% to 20% by mass, or 0.5% to 10% by mass.

[Step of treating ionic substituent such as phosphoric acid-derived group with organic ion]

In the production of the sheet of the present invention, the ionic substituent is treated with an organic ion before the step (3).

This step may be carried out before the fibrillation treatment in the step (2). Specifically, an organic ion (an organic onium ion, etc.) is poured into a dispersion of fibers before a fibrillation treatment. This aspect is advantageous in that the load of washing an organic ion (an organic onium ion, etc.) is low, and in that redundant organic ions (organic onium ions, etc.) can be sufficiently removed by washing. In addition, this aspect is also advantageous in that, since such redundant organic ions (organic onium ions, etc.) can be sufficiently removed, the transparency of the obtained sheet is further increased.

This step can also be carried out after the fibrillation treatment in the step (2). Specifically, an organic ion (an organic onium ion, etc.) is poured into a dispersion of ultrafine fibers after completion of the fibrillation treatment. According to this aspect, organic ions (organic onium ions, etc.) can be introduced into many types.

The treatment method using an organic ion (an organic onium ion, etc.) is not particularly limited, as long as the ionic substituent comprised in fibers is capable of forming an ion pair with the organic ion (the organic onium ion, etc.). Typically, this treatment method is carried out by adding an aqueous solution of a compound used as an organic ion (organic onium ion, etc.) source to fibers before the fibrillation treatment or a dispersion of ultrafine fibers. The concentration of the used aqueous solution depends on the solubility of the compound in water, and it can be set at 0.1% by mass or more, preferably 1.0% by mass or more, and more preferably 5.0% by mass or more. The upper limit value may be determined from the economic viewpoint, but from the viewpoint of ensuring the transparency of a sheet, it is preferably 40% by mass or less, and more preferably 35% by mass or less. The amount of the used organic ion (organic onium ion, etc.) is preferably an amount in which the organic ion is capable of forming an ion pair with many ionic substituents (phosphoric acid-derived groups, etc.) introduced into the sheet. For example, the organic ion can be used in an amount in which it is capable of forming an ion pair with at least 50% or more of, preferably 60% or more of, more preferably 70% or more of, further preferably 80% or more of , and still further preferably 90% or more of ionic substituents possessed by the introduced substituents.

After completion of the treatment using an organic ion (an organic onium ion, etc.), washing is carried out, as necessary. The washing can be carried out with water, or an aqueous solvent, and preferably with water.

It is considered that an organic ion (an organic onium ion, etc.) forms an ion pair with an ionic substituent on fibers as a result of the treatment using the organic ion (the organic onium ion, etc.), and thus that agglutination of ultrafine fibers is suppressed upon sheet formation. It is thereby considered that generation of wrinkles and/or cracks on the sheet is suppressed. Moreover, it is considered that the sheet can be dried at a higher temperature and in a shorter time.

[Step (3): Step of preparing sheet from ionic substituent-introduced ultrafine fibers that have been treated with organic ion], and

[Step (3): Step of preparing sheet from phosphoric acid-derived group-introduced ultrafine fibers that have been treated with organic onium ion]

A sheet is prepared from a dispersion of ultrafine fibers (slurry) obtained by a fibrillation treatment. The method of preparing a sheet is not particularly limited, and it can typically be based on, for example, the following papermaking method, the following coating method, and the like.

< Papermaking method >

The ultrafine fiber-containing slurry can be subjected to papermaking by a known papermaking method, such as a continuous paper machine (e.g., a Fourdrinier type, a cylinder type, or an inclined type) which is used in ordinary papermaking, a multilayer paper machine as a combination thereof, or hand papermaking, and can be formed into a sheet by the same method as in general paper. Specifically, the ultrafine fiber-containing slurry can be filtered and dehydrated on a wire to obtain a sheet in a wet paper state, followed by pressing and drying to obtain a sheet. The concentration of the slurry is not particularly limited and is preferably 0.05% to 5% by mass. Too low a concentration requires a huge amount of time for filtration. On the other hand, too high a concentration does not produce a homogeneous sheet and is therefore not preferable. For the filtration and dehydration of the slurry, the filter fabric for use in the filtration is not particularly limited, and it is important that the ultrafine fiber does not pass through the filter fabric and the filtration rate is not too slow. Such a filter fabric is not particularly limited and is preferably a sheet, a woven fabric, or a porous membrane made of an organic polymer. The organic polymer is not particularly limited and is preferably a non-cellulosic organic polymer such as polyethylene terephthalate, polyethylene, polypropylene, or polytetrafluoroethylene (PTFE).

Specific examples thereof include, but are not particularly limited to, a porous membrane of polytetrafluoroethylene having a pore size of 0.1 to 20 μm, for example, 1 μm, and a woven fabric of polyethylene terephthalate or polyethylene having a pore size of 0.1 to 20 μm, for example, 1 μm.

< Coating method >

The coating method is a method which involves coating a base material with the ultrafine fiber-containing slurry, drying the resultant, and detaching the formed ultrafine fiber-containing layer from the base material to obtain a sheet. The method can continuously produce sheets by using a coating apparatus and a long base material. The quality of the base material is not particularly limited, and a base material having higher wettability against the ultrafine fiber-containing slurry is more preferable because the contraction or the like of the sheet during drying can be suppressed. It is preferable to select a base material that allows the formed sheet to be easily detached after drying. Among others, a resin plate or a metal plate is preferable, though the base material is not particularly limited thereto. Such appropriate base materials are preferably used each alone or in a stacked form. Examples of the base material that can be used herein include, but are not particularly limited to: resin plates such as acrylic plates, polyethylene terephthalate plates, vinyl chloride plates, polystyrene plates, and polyvinylidene chloride plates; metal plates such as aluminum plates, zinc plates, copper plates, and iron plates; plates obtained by the oxidation treatment of their surface; and stainless plates and brass plates. Various coaters capable of coating the base material with a predetermined amount of the slurry can be used for coating the base material with the ultrafine fiber-containing slurry. For example, a roll coater, a gravure coater, a die coater, a curtain coater, a spray coater, a blade coater, a rod coater, or an air doctor coater can be used, though the coater is not particularly limited thereto. Among them, a coating manner such as a die coater, a curtain coater, a spray coater, or an air doctor coater is effective for uniform coating. In the case of, for example, preparing the sheet into a laminate as mentioned later, the detachment from the base material may not be carried out.

< Sheet thickness >

The thickness of the sheet to be prepared is not particularly limited and can be appropriately set according to purposes. The amount of the slurry can be measured on the basis of the finished basis weight or thickness of the sheet to carry out papermaking or coating, etc.

< Dehydration and drying >

After the papermaking or the coating, etc., at least one of dehydration and drying is carried out, as necessary, to form a sheet. In the production of the sheet of the present invention, since the treatment in the subsequent step (4) is carried out in a predetermined aqueous solution to reduce organic ions, dehydration and drying can be carried out until water content is removed to a certain extent. Thus, it is considered that the dehydration and the drying do not have to be completely performed as in the case of obtaining a usual sheet as a final product.

Examples of the dehydration method include, but are not particularly limited to, a dehydration method usually used for paper production. A method which involves dehydration with, for example, a Fourdrinier, cylinder, or inclined wire and then dehydration with a roll press is preferable. Examples of the drying method include, but are not particularly limited to, a method for use in paper production. For example, a method such as a cylinder dryer, a yankee dryer, hot air drying, or an infrared heater is preferable.

The drying method is not particularly limited, and any of a contactless drying method and a method of drying the sheet while locking the sheet can be used, or these methods may be combined.

The contactless drying method is not particularly limited, and a method for drying by heating with hot air, infrared radiation, far-infrared radiation, or near-infrared radiation (drying method by heating) or a method for drying in vacuum (vacuum drying method) can be applied. Although the drying method by heating and the vacuum drying method may be combined, the drying method by heating is usually applied. The drying with infrared radiation, far-infrared radiation, or near-infrared radiation can be performed using an infrared apparatus, a far-infrared apparatus, or a near-infrared apparatus, but the used apparatus is not particularly limited thereto. The heating temperature for the drying method by heating is not particularly limited and is preferably 40°C to 120°C, and more preferably 40°C to 105°C. At the heating temperature equal to or higher than the lower limit described above, the dispersion medium can be rapidly volatilized. At the heating temperature equal to or lower than the upper limit described above, cost required for the heating can be reduced and the thermal discoloration of the ultrafine fibers can be suppressed.

(Other fibers)

For the preparation of the sheet, the sheet is not particularly limited and can also be prepared by mixing the

ultrafine fibers with at least one or more fibers other than the ultrafine fibers (hereinafter, referred to as "additional fiber"). Examples of the additional fiber include, but are not particularly limited to, inorganic fiber, organic fiber, synthetic fiber, semisynthetic fiber, and regenerated fiber. Examples of the inorganic fiber include, but are not limited to, glass fiber, rock fiber, and metal fiber. Examples of the organic fiber include, but are not limited to, natural product-derived fiber such as cellulose, carbon fiber, pulp, chitin, and chitosan. Examples of the synthetic fiber include, but are not limited to, nylon, vinylon, vinylidene, polyester, polyolefin (e.g., polyethylene and polypropylene, etc.), polyurethane, acryl, polyvinyl chloride, and aramid. Examples of the semisynthetic fiber include, but are not limited to, acetate, triacetate, and promix. Examples of the regenerated fiber include, but are not limited to, rayon, cupra, polynosic rayon, lyocell, and Tencel. The additional fiber can be subjected to a treatment such as a chemical treatment or a defibration treatment, as necessary.

The mixing is not particularly limited and can be carried out, for example, by adding the additional fiber to the ultrafine fiber-containing slurry before papermaking or coating. In the case of subjecting the additional fiber to a treatment such as a chemical treatment or a defibration treatment, the additional fiber may be subjected to the treatment such as a chemical treatment or a defibration treatment after being mixed with the ultrafine fibers, or may be mixed with the ultrafine fibers after being subjected to the treatment such as a chemical treatment or a defibration treatment. The mixing of the ultrafine fibers and the additional fiber having similar average fiber diameters is preferable because of further facilitating uniform mixing.

For the mixing with the additional fibers, the amount of the additional fibers added with respect to the total amount of the ultrafine fibers and the additional fibers is not particularly limited, and it is preferably 50% by mass or less, more preferably 40% by mass or less, further preferably 30% by mass or less, and particularly preferably 20% by mass or less.

A hydrophilic polymer may be added for the preparation of the sheet. Examples of the hydrophilic polymer can include, but are not particularly limited to, polyethylene glycol, cellulose derivatives (hydroxyethylcellulose, carboxyethylcellulose, carboxymethylcellulose, etc.), casein, dextrin, starch, modified starch, polyvinyl alcohol, modified polyvinyl alcohol (acetoacetylated polyvinyl alcohol, etc.), polyethylene oxide, polyvinylpyrrolidone, polyvinyl methyl ether, polyacrylates, polyacrylamide, acrylic acid alkyl ester copolymers, and urethane copolymers.

Also, a hydrophilic low-molecular-weight compound can be used instead of the hydrophilic polymer. Examples of the hydrophilic low-molecular-weight compound can include, but are not particularly limited to, glycerin, erythritol, xylitol, sorbitol, galactitol, mannitol, ethylene glycol, diethylene glycol, propylene glycol, dipropylene glycol, and butylene glycol.

The mixing of the hydrophilic polymer or the hydrophilic low-molecular-weight compound is not particularly limited and can be carried out, for example, by adding the hydrophilic polymer or the hydrophilic low-molecular-weight compound to the ultrafine fiber-containing slurry before papermaking or coating. For the addition of the hydrophilic polymer or the hydrophilic low-molecular-weight compound, the amount of the hydrophilic polymer or the hydrophilic low-molecular-weight compound added is not particularly limited and is preferably 1 to 200 parts by mass, more preferably 1 to 150 parts by mass, further preferably 2 to 120 parts by mass, and particularly preferably 3 to 100 parts by mass, with respect to 100 parts by mass (solid content) of the ultrafine fibers.

[Step (4): Step of reducing organic ions comprised in sheet]

The production of the sheet of the present invention comprises a step of reducing organic ions comprised in the sheet, after completion of the step (3). The method of reducing organic ions is not particularly limited, as long as organic ions can be reduced to a desired extent. Examples of the method of reducing organic ions that can be applied herein include a method of eliminating organic ions together with ionic substituents forming an ion pair with the organic ions (elimination of ionic substituents) and a method of exchanging organic ions with other ions (counterion exchange).

< Elimination of ionic substituents >

By eliminating all or a part of the introduced ionic substituents, organic ions can be removed from the sheet. Such elimination can be carried out by treating the sheet obtained in the step (3) with at least one of water and alcohol. Herein, alcohol includes polyhydric alcohol, and when such polyhydric alcohol is used, elimination can be achieved by boiling the sheet with polyhydric alcohol, and can also be achieved by treating the sheet with vapor of polyhydric alcohol. When at least one of water and alcohol having a low boiling point is used, elimination can be achieved by treating the sheet with vapor of polyhydric alcohol.

(Polyhydric alcohol boiling method)

In one preferred aspect of the present invention, when the substituent is eliminate in the step (4), the sheet is treated by being boiled with polyhydric alcohol. Polyhydric alcohol means alcohol having two or more OH groups. In the

case of using such polyhydric alcohol, it is preferable to use polyhydric alcohol in which the OH/C ratio is 0.15 or more. It is more preferable to use polyhydric alcohol in which the OH/C ratio is 0.2 or more. The "OH/C ratio" means the number of OH groups per carbon (C) atom contained in a molecule. For example, the OH/C ratio of ethylene glycol ($C_2H_5O_2$) is 1, and the OH/C ratio of diethylene glycol ($C_4H_{10}O_3$) is 0.67.

Examples of polyhydric alcohol in which the OH/C ratio is 0.2 or more include ethylene glycol, diethylene glycol, propylene glycol (1,2-propanediol), glycerin (glycerol, 1,2,3-propanetriol), pentanediol, octanediol, decanediol, and sugar alcohol (e.g., sorbitol, lactitol, maltitol, mannitol, and xylitol).

The amount of polyhydric alcohol used in the boiling treatment in the step (4) is not particularly limited, as long as elimination of substituents can be sufficiently carried out. The used amount of polyhydric alcohol can be determined, as appropriate, based on the mass of the sheet. Regardless of the type of alcohol used, the alcohol can be used in an amount of 1 to 100 parts by mass, based on 1 part by mass of the sheet. If the used amount of alcohol is smaller than 1 part by mass based on 1 part by mass of the sheet, there may be a case where elimination cannot be sufficiently carried out.

The temperature applied in the boiling treatment is not particularly limited, as long as elimination of substituents can be sufficiently carried out. The temperature can be set at 140°C or higher, and it is preferably 160°C or higher, and more preferably 170°C or higher. It is preferable to select the temperature at which decomposition of the fiber raw material is suppressed, and it is not particularly limited. For example, when cellulose is used as a fiber raw material, the temperature for the boiling treatment is 250°C or lower, and further preferably 200°C or lower. In addition, during heating, additives such as an acid or a base may be added, as appropriate.

The time required for the boiling treatment is not particularly limited, as long as elimination of substituents can be sufficiently carried out. For example, when glycerin that is polyhydric alcohol having an OH/C ratio of 1 is used as alcohol and the boiling treatment is carried out at 180°C, the boiling treatment time can be set at 10 to 120 minutes, and it is preferably 15 to 90 minutes, and more preferably 15 to 60 minutes. The same conditions as described above can be applied also in the case of using other alcohols.

(Vapor method)

When substituents are eliminated in the step (4), vapor may be used. The type of vapor is not particularly limited. It is considered that as long as it is the vapor of a substance having an OH group, it can eliminate the introduced substituents. From the viewpoint of high ability to eliminate substituents, the vapor is preferably at least one of water vapor and alcohol vapor. Examples of the alcohol include methanol, ethanol, n-propanol, isopropanol, n-butanol, isobutyl alcohol, t-butanol, and the aforementioned polyhydric alcohols. A particularly preferred example of the vapor is water vapor. The water vapor may comprise: water; lower alcohol such as methanol, ethanol or propanol, or alcohol preferably containing 1 or more and 6 or less carbon atoms, more preferably containing 1 or more and 3 or less carbon atoms; ketone containing 3 or more and 6 or less carbon atoms, such as acetone, methyl ethyl ketone or methyl isobutyl ketone; linear or branched saturated hydrocarbon or unsaturated hydrocarbon containing 1 or more and 6 or less carbon atoms; or aromatic hydrocarbon such as benzene or toluene.

The treatment using vapor in the step (4) is not particularly limited, and it can be carried out by allowing the sheet to come into contact with pressurized vapor (pressurized saturated vapor) or superheated vapor.

The treatment using pressurized vapor can be carried out, for example, using the autoclave of the conventional technique. The common autoclave has, for example, a cylindrical vessel and a cap that opens or closes the upper opening portion of the vessel. An exhaust port, a thermometer, and a pressure gauge are established on the cap, and a drain value is established on the bottom portion of the vessel. Upon the use of this autoclave, first, water is added into the vessel while the drain valve is closed, a sheet is then established at an upper portion of water in the vessel, and the cap is closed. Thereafter, the exhaust port is opened, and the vessel is then heated, so that air in the vessel is initially discharged from the exhaust port, and then, vapor is gradually blown out. At the stage in which the vessel is filled with vapor, the exhaust port is closed, and thereafter, heating is continued while the temperature and the pressure are adjusted. At the stage in which the predetermined time has passed, the heating is terminated, the vessel is then cooled, and the sheet is removed from the vessel.

The treatment using pressurized vapor in the step (4) can be carried out, for example, in the temperature range of 100°C to 250°C. From the viewpoint of treatment efficiency, the temperature can be set at 100°C or higher, and it is preferably 120°C or higher, and more preferably 140°C or higher. In addition, from the viewpoint of prevention of coloration of the sheet, the temperature can be set at 250°C or lower, and it is preferably 200°C or lower, and more preferably 180°C or lower.

The treatment pressure applied in the treatment with pressurized vapor in the step (4) is preferably 0.1 MPa or more, more preferably 0.5 MPa or more, and further preferably 0.8 MPa or more. In all cases, the treatment pressure is preferably 30 MPa or less, more preferably 25 MPa or less, further preferably 20 MPa or less, and still further preferably 18 MPa or less.

The treatment time applied in the treatment with pressurized vapor in the step (4) depends on the temperature and the pressure, and the treatment can be carried out until desired elimination can be achieved. The treatment time is, for example, 5 or more minutes, preferably 10 or more minutes, and more preferably 30 or more minutes. In all cases, the treatment time can be set at 24 hours or shorter, preferably 10 hours or shorter, and further preferably 3 hours or shorter. It is to be noted that the treatment time indicates a time period, in which a heating temperature is maintained, after the time for reaching the heating temperature is set at 0 hour.

The treatment using superheated vapor can be carried out, for example, by blowing superheated vapor against the sheet. The superheated vapor is blown from the nozzle against the sheet, for example, in a supply amount of 500 $g/m^3$ to 600 $g/m^3$. The temperature of the superheated vapor can be regulated to be 100°C to 160°C at 1 atm. In this case, the time required for supplying the superheated vapor can be set at 4 seconds to 120 seconds.

< Counterion exchange >

The organic ion can be removed from the sheet by performing counterion exchange with another suitable ion. When the ionic substituent is an anionic substituent, the counterion to be exchanged is not particularly limited, and examples of such counterion include a hydrogen ion, an alkali metal ion, and an alkaline-earth metal ion. More specific examples include a hydrogen ion, a lithium ion, a sodium ion, a potassium ion, a rubidium ion, a cesium ion, a calcium ion, a strontium ion, a barium ion, a europium ion, a thallium ion, and a guanidine ion. Preferred examples include a sodium ion, a potassium ion, and a calcium ion.

Before performing counterion exchange, an acid treatment can be carried out on fibers having an anionic substituent. The acid used in the acid treatment is preferably an acid having the degree of ionization that is higher than that of the anionic substituent, but it is not particularly limited. The acid treatment can be carried out, for example, using one or two or more selected from the group consisting of hydrochloric acid, nitric acid and sulfuric acid. By performing such a treatment, the ionic substituent is sufficiently converted to an H-type substituent, and it becomes possible to more easily add a counterion replaced for the organic ion to the ionic substituent. With regard to the method and conditions for the acid treatment, the acid treatment in the aforementioned step (1) can be referred to.

< Sheet formation >

The step (4) can be carried out until the organic ions are reduced to a desired extent. After completion of the treatment by ion exchange, washing, dehydration and/or drying are carried out, as necessary, so as to obtain a sheet as a final product. The washing can be carried out using water or an aqueous solvent, and preferably with water. The dehydration and/or the drying can be carried out by the method and under the conditions, which are explained in the section of the step (3).

In the sheet of the present invention, while the advantage that generation of wrinkles and/or cracks on the sheet can be suppressed upon the formation of the sheet using organic ions is maintained, such organic ions, which may influence on the strength of the sheet after completion of the sheet formation, are reduced to an appropriate extent. Accordingly, a sheet also excellent in terms of strength can be produced. In addition, since organic ions are reduced, coloration caused by a high-temperature treatment is suppressed.

3. Lamination of sheets, intended use, and the like

The sheet of the present invention can be used as an object consisting of a single layer of the sheet, but it can also be used as a laminate by forming at least one of an organic layer and an inorganic layer on at least one surface thereof. According to lamination, resistance to water (water proofness, moisture resistance, and water repellency) can also be obtained. In the case of laminating an inorganic layer and an organic layer thereon, the order is not particularly limited. It is preferable that the organic layer be first laminated on the surface of the base sheet, because the surface for forming the inorganic layer can be smoothened and the inorganic layer to be formed can have fewer defects. The composite sheet may also comprise an additional constituent layer other than the organic layer and the inorganic layer, for example, an easily adhesive layer for facilitating the adhesion of an upper layer. In the case of using the sheet for purposes that place special emphasis on transparency, it is preferable that the lamination should not involve a heating step or a UV irradiation step, which usually accelerates the yellowing of the sheet. The laminate obtained by the lamination preferably comprises at least one inorganic layer and at least one organic layer formed on at least one side of a base sheet layer consisting of the ultrafine fiber-containing sheet. The number of layers including the inorganic layer, the organic layer, etc., is not particularly limited. For example, 2 to 15 alternated layers of the inorganic layer and the organic layer are preferably laminated, and 3 to 7 alternated layers thereof are more preferably laminated, on one side from the viewpoint of attaining adequate moisture resistance while maintaining flexibility and transparency.

Examples of the substance constituting the inorganic layer include, but are not particularly limited to: aluminum,

silicon, magnesium, zinc, tin, nickel, and titanium; their oxides, carbides, nitrides, oxycarbides, oxynitrides, and oxycarbonitrides; and mixtures thereof. Silicon oxide, silicon nitride, silicon oxycarbide, silicon oxynitride, silicon oxycarbonitride, aluminum oxide, aluminum nitride, aluminum oxycarbide, aluminum oxynitride, or a mixture thereof is preferable from the viewpoint that high moisture barrier properties can be stably maintained.

Examples of the resin that is used for forming the organic layer include, but are not particularly limited to, epoxy resins, acrylic resins, oxetane resins, silsesquioxane resins, phenol resins, urea resins, melamine resins, unsaturated polyester resins, silicon resins, polyurethane resins, silsesquioxane resins, and diallyl phthalate resins. For obtaining a low-water-absorbing laminate, it is preferable that the resin should have a small content of a hydrophilic functional group such as a hydroxy group, a carboxyl group, or an amino group.

The sheet and the laminate of the present invention are excellent in terms of transparency and have strength. Therefore, the sheet and the laminate are suitable for use as a packaging material for foods, cosmetics, pharmaceuticals, personal computers, home electronics, and the like by exploiting properties such as a light weight.

The sheet and the laminate provided according to a preferred aspect cause suppressed yellowing and are excellent in terms of optical properties. Therefore, the sheet and the laminate are suitable for use as a display element, a lighting element, a solar cell, or a window material, or a panel or a substrate therefor. More specifically, the sheet and the laminate are suitable for use as a flexible display, a touch panel, a liquid crystal display, a plasma display, an organic EL display, a field emission display, a display for rear-projection television or the like, or a LED element.

Moreover, the sheet and the laminate are suitable for use as a substrate for solar cells such as silicon solar cells and dye-sensitized solar cells. For purposes as the substrate, a barrier film, ITO, TFT, or the like may be laminated thereon. Furthermore, the laminate, etc. is suitable for use as a window material for automobiles, rail vehicles, aircrafts, houses, office buildings, factories, and the like. For the window material, a film such as a fluorine coating or a hard coat film, or an impact-resistant or light-resistant material may be laminated thereon, as necessary.

The sheet and the laminate can also be used as a structural material for purposes other than transparent materials by exploiting properties such as a low linear expansion rate, high elasticity, high strength, and a light weight. Particularly, the sheet and the laminate can be preferably used as a material for automobiles, rail vehicles, or aircrafts, such as glazing, an interior material, an outer panel, or a bumper, a case for personal computers, a component for home electronics, a material for packaging, a building material, a construction material, a fishery material, other industrial materials, and the like.

The sheet and the laminate can be used in various products. Examples of the product can include various products such as: computers, tablet terminals, and mobile phones using the display elements or the displays mentioned above; electric bulbs, lightings (lighting devices and lighting apparatuses), guidance lights, backlights for liquid crystal panels, flashlights, headlamps for bicycles, interior lights and meter lamps for automobiles, traffic light machines, altitude lightings within or without buildings, home lightings, school lightings, medical lightings, factory lightings, lights for plant growth, illumination for video lightings, lightings for around-the-clock or late-night shops such as convenience stores, and illuminating lamps for refrigerators or freezers using the lighting elements; and houses, buildings, automobiles, rail vehicles, aircrafts, and home electronics using the window materials or the structural materials.

The present invention is specifically explained with reference to the Examples below; however, the present invention is not limited to the Examples.

Examples

< Experimental Example 1 >

[Production of phosphorylated pulp]

Pulp manufactured by Oji Paper Co., Ltd. (solid content: 93% by mass, basis weight: 208 g/$m^2$, sheet-shaped, Canadian Standard Freeness (CSF) measured according to JIS P 8121 after defibration: 700 ml) was used as needle kraft pulp. 100 Parts by mass (absolute dry mass) of the needle kraft pulp were impregnated with a mixed aqueous solution of ammonium dihydrogen phosphate and urea, and were then compressed to result in 49 parts by mass of the ammonium dihydrogen phosphate and 130 parts by mass of the urea, so as to obtain chemical-impregnated pulp. The obtained chemical-impregnated pulp was dried in a dryer of 105°C for moisture evaporation to pre-dry the chemical-impregnated pulp. Then, the chemical-impregnated pulp was heated in an air-blow dryer set at 140°C for 10 minutes, so that a phosphoric acid-derived group was introduced into cellulose in the pulp to obtain phosphorylated pulp.

[Washing of phosphorylated pulp]

10000 Parts by mass of ion exchange water were poured onto 100 parts by mass (absolute dry mass) of the obtained phosphorylated pulp, which was then uniformly dispersed by stirring, followed by filtration and dehydration to

obtain a dehydrated sheet. This step was repeated twice to obtain a dehydrated sheet A of the phosphorylated pulp.

[Multiple times of phosphorylation]

The dehydrated sheet A of the obtained phosphorylated pulp was used as a raw material, and the step of introducing a phosphoric acid-derived group and the step of performing filtration and dehydration were repeated twice in the same manner as described above (a total number of phosphorylation and filtration dehydration: three times) to obtain a dehydrated sheet B of the phosphorylated pulp.

[Content of substituent introduced]

In the dehydrated sheet B of the phosphorylated pulp, the amount of the introduced phosphoric acid-derived group obtained by the following titration method was 1.4 mmol/g.

[Measurement of the amount of substituent introduced (the amount of phosphoric acid-derived group introduced)]

The amount of the substituent introduced is the amount of a phosphoric acid-derived group introduced into a fiber raw material. The greater this value, the more the phosphoric acid-derived groups that are introduced therein. The amount of the substituent introduced was measured by diluting the target ultrafine cellulose fibers with ion exchange water to have a content of 0.2% by mass, followed by a treatment with an ion exchange resin and titration using an alkali. In the treatment with an ion exchange resin, a strongly acidic ion exchange resin (Amberjet 1024; Organo Corp.; conditioning agent) was added at a volume ratio of 1/10 to the slurry containing 0.2% by mass of ultrafine cellulose fibers, followed by a stirring treatment for 1 hour. Then, the suspension was poured onto a mesh having an opening of 90 μm, so that the slurry was separated from the resin. In the titration using an alkali, a 0.1 N sodium hydroxide aqueous solution was added to the slurry containing the ultrafine cellulose fibers after the ion exchange, which change in the value of electrical conductivity exhibited by the slurry was measured. Specifically, the amount of the alkali (mmol) required for the first region in the curve shown in Fig. 1 was divided by the solid content (g) in the slurry to be titrated to determine the amount of the substituent introduced (mmol/g).

It is to be noted that addition of alkali in conductometric titration gives the curve shown in Fig. 1. At first, electrical conductivity sharply decreases (referred to as a "first region"). Then, the conductivity starts to slightly increase (hereinafter referred to as a "second region"). Thereafter, the increase in the conductivity increases (hereinafter referred to as a "third region"). The boundary point between the second region and the third region is defined as a point at which a change amount in the two differential values of conductivity, namely, an increase in the conductivity (inclination) becomes maximum.

[Conversion of counterion in phosphorylated pulp (to H type)]

To 100 parts by mass (absolute dry mass) of the dehydrated sheet B of the phosphorylated pulp, 5000 parts by mass of ion exchange water was added for dilution. Subsequently, while stirring, 1 N hydrochloric acid was slowly added to the diluted solution to obtain pulp slurry with pH 2 to 3. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that redundant hydrochloric acid was fully washed away. According to the above-described procedures, there was obtained phosphorylated pulp (H type), in which the counterion of the phosphoric acid-derived group was converted to a hydrogen (H) ion.

[Addition of organic counterion to phosphorylated pulp]

To 100 parts by mass (absolute dry mass) of the phosphorylated pulp (H type), 5000 parts by mass of ion exchange water was added for dilution. Subsequently, while stirring, an aqueous solution containing 10% by mass of tetrabutylammonium hydroxide was slowly added to the diluted solution to obtain pulp slurry with pH 10 to 12. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that a redundant tetrabutylammonium hydroxide aqueous solution was fully washed away. According to the above-described procedures, there was obtained phosphorylated pulp (TBA type), in which the counterion of the phosphoric acid-derived group was converted to a tetrabutylammonium (TBA) ion.

[Mechanical treatment]

Ion exchange water was added to the phosphorylated pulp (TBA type) to obtain 1.0% by mass of a pulp suspension. This pulp suspension was passed through a wet-type atomizing device ("ALTIMIZER" manufactured by Sugino Machine Ltd.) at a pressure of 245 MPa, 5 times, to obtain an ultrafine cellulose fiber suspension (TBA type).

[Sheet formation]

The concentration of the ultrafine cellulose fiber suspension (TBA type) was adjusted, so that the concentration of the solid content could be 0.5% by mass. The suspension was weighed so that the finished basis weight of a sheet could be 75 $g/m^2$, and it was then applied onto a commercially available acrylic plate, followed by drying in a thermo-hygrostat at 35°C at 15% RH. Besides, in order to obtain a predetermined basis weight, a metallic mold (180 mm square) for damming was disposed on the acrylic plate. According to these procedures, an ultrafine cellulose fiber sheet (TBA type) was obtained.

[Dephosphorylation (removal of phosphoric acid-derived group and counterion)]

A heat-resistant rubber sheet (X-30-4084-U, manufactured by Shin-Etsu Chemical Co., Ltd.), on which a void (150 mm square) had been made, was placed as a spacer on a stainless steel plate, and 50 mL of glycerin was applied into the void. An ultrafine cellulose fiber sheet (TBA type) cut into a 120 mm square was immersed therein, and a stainless steel plate was then placed thereon, followed by establishing it in a heat pressing machine heated to 180°C (Compact Vacuum Heating Press, manufactured by Imoto Machinery Co., Ltd.). The ultrafine cellulose fiber sheet (TBA type) was treated at 180°C for 30 minutes, and was then immersed in 500 mL of water, followed by washing. The washing was repeated three times, and the ultrafine cellulose fiber sheet was attached to a glass plate, and was then dried by heating at 100°C for 15 minutes, so as to obtain an ultrafine cellulose fiber sheet, from which a phosphoric acid-derived group and a counterion were removed.

< Experimental Example 2 >

[Conversion of counterion in phosphorylated pulp (to Na type)]

When the counterion (TBA type) in the phosphorylated pulp of Experimental Example 1 was converted to another counterion, a 1 N NaOH aqueous solution was used, instead of an aqueous solution containing 10% by mass of tetrabutylammonium hydroxide, so as to obtain phosphorylated pulp (Na type), in which the counterion of the phosphoric acid-derived group was converted to a sodium (Na) ion.

[Mechanical treatment]

Ion exchange water was added to the phosphorylated pulp (Na type) to obtain 1.0% by mass of a pulp suspension. This pulp suspension was passed through a wet-type atomizing device ("ALTIMIZER" manufactured by Sugino Machine Ltd.) at a pressure of 245 MPa, 5 times, to obtain an ultrafine cellulose fiber suspension (Na type).

[Conversion of counterion in ultrafine cellulose fiber suspension (Na type) (to H type)]

The ultrafine cellulose fiber suspension (Na type) was diluted with ion exchange water to 0.5% by mass, and a strongly acidic ion exchange resin (Amberjet 1024; Organo Corp.; conditioning agent) was added at a volume ratio of 1/10 to the diluted solution, followed by a stirring treatment for 1 hour. Then, the suspension was poured onto a mesh having an opening of 51 μm, followed by vacuum filtration, so that the slurry was separated from the resin. According to the above-described procedures, there was obtained an ultrafine cellulose fiber suspension (H type), in which the counterion of the phosphoric acid-derived group was converted to a hydrogen (H) ion.

[Addition of organic counterion to ultrafine cellulose fiber suspension (H type)]

10% By mass of a tetrabutylammonium hydroxide aqueous solution was weighed, so that the content of a phosphoric acid-derived group (1.5 mmol/g) became equal to the content of a tetrabutylammonium ion, and the aqueous solution was then added to the ultrafine cellulose fiber suspension (H type). Thereafter, a stirring treatment was carried out for 1 hour, and as a result, there was obtained an ultrafine cellulose fiber suspension (TBA type), in which the counterion of the phosphoric acid-derived group was converted to a tetrabutylammonium (TBA) ion.

The subsequent procedures were carried out in the same manner as that of Experimental Example 1 to obtain an ultrafine cellulose fiber sheet, from which the phosphoric acid-derived group and the organic counterion were removed.

< Experimental Example 3 >

[Counterion exchange (removal of organic counterion)]

The ultrafine cellulose fiber sheet (TBA type) obtained in Experimental Example 2 was immersed in hydrochloric acid whose pH had been adjusted to pH 2 for 30 minutes to remove the tetrabutylammonium ion from the ultrafine cellulose fiber sheet (TBA type), so that the counterion of the phosphoric acid-derived group was converted to a hydrogen (H) ion. Thereafter, the ultrafine cellulose fiber sheet was immersed in a sodium hydroxide aqueous solution whose pH had been adjusted to pH 12 for 5 minutes, so that the counterion of the phosphoric acid-derived group was converted to a sodium (Na) ion. The ultrafine cellulose fiber sheet was attached to a glass plate, and was then dried by heating at 100°C for 15 minutes. According to the above-described procedures, there was obtained an ultrafine cellulose fiber sheet, from which the organic counterion was removed.

< Experimental Example 4 >

The same operation as that of Experimental Example 2 was carried out, with the exception that an aqueous solution containing 10% by mass of tetraethylammonium hydroxide was used instead of an aqueous solution containing 10% by mass of tetrabutylammonium hydroxide, when an organic counterion was added to the ultrafine cellulose fiber suspension (H type) of Experimental Example 2, so as to obtain an ultrafine cellulose fiber sheet, from which the phosphoric acid-derived group and the organic counterion were removed.

< Experimental Example 5 >

The same operation as that of Experimental Example 2 was carried out, with the exception that an aqueous solution containing 10% by mass of tetrabutylphosphonium hydroxide was used instead of an aqueous solution containing 10% by mass of tetrabutylammonium hydroxide, when an organic counterion was added to the ultrafine cellulose fiber suspension (H type) of Experimental Example 2, so as to obtain an ultrafine cellulose fiber sheet, from which the phosphoric acid-derived group and the organic counterion were removed.

< Experimental Example 6 >

The same operation as that of Experimental Example 2 was carried out, with the exception that a 30-mass-% lauryltrimethylammonium chloride aqueous solution ("Kachiogen TML" manufactured by Dai-ichi Kogyo Seiyaku Co., Ltd.) was used instead of an aqueous solution containing 10% by mass of tetrabutylammonium hydroxide, when an organic counterion was added to the ultrafine cellulose fiber suspension (H type) of Experimental Example 2, so as to obtain an ultrafine cellulose fiber sheet, from which the phosphoric acid-derived group and the organic counterion were removed.

< Experimental Example 7 >

[Production of TEMPO oxidized pulp (TEMPO oxidation reaction)]

Undried needle bleached kraft pulp manufactured by Oji Paper Co., Ltd. corresponding to a dry mass of 100 parts by mass, 1.25 parts by mass of TEMPO, and 12.5 parts by mass of sodium bromide were dispersed in 10000 parts by mass of water. Subsequently, an aqueous solution containing 13% by mass of sodium hypochlorite was added thereto, such that the amount of sodium hypochlorite was 8.0 mmol with respect to 1.0 g of the pulp, to start reaction. During the reaction, the pH was kept at 10 to 11 by the dropwise addition of a 0.5 M sodium hydroxide aqueous solution. The point in time when change in pH was no longer seen was considered to be completion of the reaction.

[Washing of TEMPO oxidized pulp]

Thereafter, this pulp slurry was dehydrated to obtain a dehydrated sheet, and 5000 parts by mass of ion exchange water was poured onto the pulp, which was then uniformly dispersed by stirring, followed by filtration and dehydration to obtain a dehydrated sheet. This step was repeated twice. The amount of a substituent (carboxylic acid-derived group) introduced, which was measured by the titration method, was 1.5 mmol/g.

[Counterion exchange of TEMPO oxidized pulp]

Further, to the obtained dehydrated sheet, 5000 parts by mass of ion exchange water was added for dilution. Subsequently, while stirring, 1 N hydrochloric acid was slowly added to the diluted solution to obtain pulp slurry with pH 2 to 3. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that redundant hydrochloric acid was fully washed away. According to the above-described procedures, there was obtained TEMPO oxidized pulp (H type), in which the counterion of the carboxylic acid-derived group was converted to a hydrogen (H) ion.

[Addition of organic counterion to TEMPO oxidized pulp]

To 100 parts by mass (absolute dry mass) of the obtained TEMPO oxidized pulp (H type), 5000 parts by mass of ion exchange water was added for dilution. Subsequently, while stirring, a 10% tetrabutylammonium hydroxide aqueous solution was slowly added to the diluted solution to obtain pulp slurry with pH 10 to 12. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that a redundant tetrabutylammonium hydroxide aqueous solution was fully washed away. According to the above-described procedures, there was obtained TEMPO oxidized pulp (TBA type), in which the counterion of the carboxylic acid-derived group was converted to a tetrabutylammonium (TBA) ion.

The subsequent procedures were carried out in the same manner as that of Experimental Example 3, with the exception that the above-described TEMPO oxidized pulp (TBA type) was used instead of the phosphorylated pulp (TBA type), so as to obtain an ultrafine cellulose fiber sheet, from which the organic counterion was removed.

< Experimental Example 8 >

The same operation as that of Experimental Example 1 was carried out with the exception that the removal of the counterion (the removal of the phosphoric acid-derived group and the counterion) was not carried out, to obtain an ultrafine cellulose fiber sheet, to which a tetrabutylammonium ion was added as an organic counterion. Specific procedures are as follows.

[Production of phosphorylated pulp]

Pulp manufactured by Oji Paper Co., Ltd. (solid content: 93% by mass, basis weight: 208 $g/m^2$, sheet-shaped, Canadian Standard Freeness (CSF) measured according to JIS P 8121 after defibration: 700 ml) was used as needle kraft pulp. 100 Parts by mass (absolute dry mass) of the needle kraft pulp were impregnated with a mixed aqueous solution of ammonium dihydrogen phosphate and urea and were then compressed to result in 49 parts by mass of the ammonium dihydrogen phosphate and 130 parts by mass of the urea, so as to obtain chemical-impregnated pulp. The obtained chemical-impregnated pulp was dried in a dryer of 105°C for moisture evaporation to pre-dry the chemical-impregnated pulp. Then, the chemical-impregnated pulp was heated in an air-blow dryer set at 140°C for 10 minutes, so that a phosphoric acid-derived group was introduced into cellulose in the pulp to obtain phosphorylated pulp.

[Washing of phosphorylated pulp]

10000 Parts by mass of ion exchange water were poured onto 100 parts by mass (absolute dry mass) of the obtained phosphorylated pulp, which was then uniformly dispersed by stirring, followed by filtration and dehydration to obtain a dehydrated sheet. This step was repeated twice to obtain a dehydrated sheet A of the phosphorylated pulp.

[Multiple times of phosphorylation]

The dehydrated sheet A of the obtained phosphorylated pulp was used as a raw material, and the step of introducing a phosphoric acid-derived group and the step of performing filtration and dehydration were repeated twice in the same manner as described above (a total number of phosphorylation and filtration dehydration: three times) to obtain a dehydrated sheet B of the phosphorylated pulp.

[Content of substituent introduced]

In the dehydrated sheet B of the phosphorylated pulp, the amount of the introduced phosphoric acid-derived

group, which was obtained by the titration method described in Experimental Example 1, was 1.4 mmol/g.

[Conversion of counterion in phosphorylated pulp (to H type)]

To 100 parts by mass (absolute dry mass) of the dehydrated sheet B of the phosphorylated pulp, 5000 parts by mass of ion exchange water was added for dilution. Subsequently, while stirring, 1 N hydrochloric acid was slowly added to the diluted solution to obtain pulp slurry with pH 2 to 3. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that redundant hydrochloric acid was fully washed away. According to the above-described procedures, there was obtained phosphorylated pulp (H type), in which the counterion of the phosphoric acid-derived group was converted to a hydrogen (H) ion.

[Addition of organic counterion to phosphorylated pulp]

To 100 parts by mass (absolute dry mass) of the phosphorylated pulp (H type), 5000 parts by mass of ion exchange water was added for dilution. Subsequently, while stirring, an aqueous solution containing 10% by mass of tetrabutylammonium hydroxide was slowly added to the diluted solution to obtain pulp slurry with pH 10 to 12. Thereafter, this pulp slurry was dehydrated to obtain a dehydrated sheet, and ion exchange water was then poured onto the sheet again, followed by stirring for uniform dispersion. Subsequently, the operation of filtration and dehydration to obtain a dehydrated sheet was repeated, so that a redundant tetrabutylammonium hydroxide aqueous solution was fully washed away. According to the above-described procedures, there was obtained phosphorylated pulp (TBA type), in which the counterion of the phosphoric acid-derived group was converted to a tetrabutylammonium (TBA) ion.

[Mechanical treatment]

Ion exchange water was added to the phosphorylated pulp (TBA type) to obtain 1.0% by mass of a pulp suspension. This pulp suspension was passed through a wet-type atomizing device ("ALTIMIZER" manufactured by Sugino Machine Ltd.) at a pressure of 245 MPa, 5 times, to obtain an ultrafine cellulose fiber suspension (TBA type).

[Sheet formation]

The concentration of the ultrafine cellulose fiber suspension (TBA type) was adjusted, so that the concentration of the solid content could be 0.5% by mass. The suspension was weighed so that the finished basis weight of a sheet could be 75 $g/m^2$, and it was then applied onto a commercially available acrylic plate, followed by drying in a thermo-hygrostat at 35°C at 15% RH Besides, in order to obtain a predetermined basis weight, a metallic mold (180 mm square) for damming was disposed on the acrylic plate. According to these procedures, an ultrafine cellulose fiber sheet was obtained.

< Experimental Example 9 >

[Conversion of counterion in phosphorylated pulp (to Na type)]

When the counterion (TBA type) in the phosphorylated pulp of Experimental Example 8 was converted to another counterion, a 1 N NaOH aqueous solution was used, instead of an aqueous solution containing 10% by mass of tetrabutylammonium hydroxide, so as to obtain phosphorylated pulp (Na type), in which the counterion of the phosphoric acid-derived group was converted to a sodium (Na) ion.

[Mechanical treatment]

Ion exchange water was added to the phosphorylated pulp (Na type) to obtain 1.0% by mass of a pulp suspension. This pulp suspension was passed through a wet-type atomizing device ("ALTIMIZER" manufactured by Sugino Machine Ltd.) at a pressure of 245 MPa, 5 times, to obtain an ultrafine cellulose fiber suspension (Na type).

[Conversion of counterion in ultrafine cellulose fiber suspension (Na type) (to H type)]

The ultrafine cellulose fiber suspension (Na type) was diluted with ion exchange water to 0.5% by mass, and a strongly acidic ion exchange resin (Amberjet 1024; Organo Corp.; conditioning agent) was added at a volume ratio of

1/10 to the diluted solution, followed by a stirring treatment for 1 hour. Then, the suspension was poured onto a mesh having an opening of 51 μm, followed by vacuum filtration, so that the slurry was separated from the resin. According to the above-described procedures, there was obtained an ultrafine cellulose fiber suspension (H type), in which the counterion of the phosphoric acid-derived group was converted to a hydrogen (H) ion.

[Addition of organic counterion to ultrafine cellulose fiber suspension (H type)]

An aqueous solution containing 10% by mass of tetrabutylammonium hydroxide was weighed, so that the content of a phosphoric acid-derived group (1.5 mmol/g) became equal to the content of a tetrabutylammonium ion, and the aqueous solution was then added to the ultrafine cellulose fiber suspension (H type). Thereafter, a stirring treatment was carried out for 1 hour, and as a result, there was obtained an ultrafine cellulose fiber suspension (TBA type), in which the counterion of the phosphoric acid-derived group was converted to a tetrabutylammonium (TBA) ion. The subsequent procedures were carried out in the same manner as that of Experimental Example 8 to obtain an ultrafine cellulose fiber sheet.

< Experimental Example 10 >

An ultrafine cellulose fiber sheet was obtained by performing the same operation as that of Experimental Example 9, with the exception that an aqueous solution containing 10% by mass of tetraethylammonium hydroxide was used instead of an aqueous solution containing 10% tetrabutylammonium hydroxide, when an organic counterion was added to the ultrafine cellulose fiber suspension (H type) of Experimental Example 9.

< Experimental Example 11 >

An ultrafine cellulose fiber sheet was obtained by performing the same operation as that of Experimental Example 9, with the exception that an aqueous solution containing 10% by mass of tetrabutylphosphonium hydroxide was used instead of a 10% tetrabutylammonium hydroxide aqueous solution, when an organic counterion was added to the ultrafine cellulose fiber suspension (H type) of Experimental Example 9.

< Experimental Example 12 >

An ultrafine cellulose fiber sheet was obtained by performing the same operation as that of Experimental Example 9, with the exception that an aqueous solution containing 30% by mass of lauryltrimethylammonium chloride ("Kachiogen TML" manufactured by Dai-ichi Kogyo Seiyaku Co., Ltd.) was used instead of an aqueous solution containing 10% tetrabutylammonium hydroxide, when an organic counterion was added to the ultrafine cellulose fiber suspension (H type) of Experimental Example 9.

< Experimental Example 13 >

An ultrafine cellulose fiber sheet, to which a tetrabutylammonium ion was added as an organic counterion, was obtained by performing the same operation as that of Experimental Example 7, with the exception that the removal of the counterion was not carried out.

< Experimental Example 14 >

Counterion conversion (to H type) and addition of an organic counterion were not carried out on the ultrafine cellulose fiber suspension (Na type) obtained in Experimental Example 9, but 20 parts by mass of polyethylene oxide having a molecular weight of 4,300,000 to 4,800,000 ("PEO-18P" manufactured by Sumitomo Seika Chemicals Co., Ltd.) was added to 100 parts by mass of the ultrafine cellulose fiber suspension (Na type). The subsequent procedures were carried out in the same manner as that of Experimental Example 9 to obtain an ultrafine cellulose fiber sheet.

< Experimental Example 15 >

In Experimental Example 1, addition of an organic counterion to the phosphorylated pulp was not carried out, but a mechanical treatment and sheet formation were carried out. Significant cracks were generated upon the sheet formation, and an ultrafine cellulose fiber sheet could not be obtained.

< Evaluation >

[Method]

The ultrafine cellulose fiber sheets produced in the above-described experiment examples were evaluated according to the following evaluation methods. Since no ultrafine cellulose fiber sheets could be obtained in Experimental Example 15, evaluation was not conducted on Experimental Example 15.

(1) Content of ionic substituent in ultrafine cellulose fiber sheet

Using an X-ray fluorescence analysis device ("PW2404" manufactured by Spectris Co., Ltd.), the concentrations of phosphorus and sodium atoms in each ultrafine cellulose fiber sheet were measured. That is to say, the intensity of characteristic X ray of phosphorus or sodium atoms, which were released when outer-shell electrons were transferred into voids generated as a result of the excitation of the inner-shell electrons of phosphorus or sodium atoms by irradiation of the ultrafine cellulose fiber sheet with X-ray, was measured, so as to obtain the concentration of phosphorus or sodium atoms. Besides, in Experimental Example 7 and Experimental Example 13, in which a carboxylic acid-derived group was comprised as an ionic substituent, the ultrafine cellulose fiber sheet was immersed in a sodium hydroxide aqueous solution adjusted to pH 12 for 5 minutes, before the analysis using the X-ray fluorescence analysis device, so that the counterion of the carboxylic acid-derived group was converted to a sodium (Na) ion.

Upon the calculation of the content of the ionic substituent from the atom concentration, the calculation was carried out using a calibration curve produced by the following method. An ultrafine cellulose fiber sheet, in which the content of the phosphoric acid-derived group was known, was produced, and was then subjected to an X-ray fluorescence analysis. Thereafter, a calibration curve was produced based on the characteristic X-ray intensity of phosphorus atoms and the content of the phosphoric acid-derived group. Also in the case of the carboxylic acid-derived group, an ultrafine cellulose fiber sheet, in which the content of the carboxylic acid-derived group was known and which was a sodium salt type, was produced, and a calibration curve was then produced based on the characteristic X-ray intensity of sodium atoms and the content of the carboxylic acid-derived group.

In Experimental Example 5 and Experimental Example 11, the concentration of the phosphorus atom derived from the after-mentioned tetrabutylphosphonium hydroxide was subtracted to obtain the content of the phosphoric acid-derived group in the ultrafine cellulose fiber sheet. With regard to all of Experimental Examples 8 to 12, it was confirmed that the content of the carboxylic acid-derived group was less than 0.1 mmol/g.

In the tables below, the thus calculated content of the phosphoric acid-derived group or the carboxylic acid-derived group with respect to ultrafine cellulose fibers is shown.

(2) Content of organic counterion

With regard to Experimental Examples 1 to 4, 6 to 10, 12 and 13, the concentration of the nitrogen atom in the sheet was measured using a trace nitrogen analysis device ("TN-110" manufactured by Mitsubishi Chemical Analytech Co., Ltd.). Specifically, the nitrogen atom concentration in a sheet, to which an organic counterion was not added, was used as a reference value, and the reference value was then subtracted from the nitrogen atom concentration of the ultrafine cellulose fiber sheet obtained in each of Experimental Examples 1 to 4, 6 to 10, 12 and 13 to obtain an organic counterion-derived nitrogen atom concentration, so that the content of the organic counterion was calculated.

With regard to Experimental Examples 5 and 11, the concentration of the phosphorus atom in the sheet was measured using an X-ray fluorescence analysis device ("PW2404" manufactured by Spectris Co., Ltd.). Specifically, the intensity of characteristic X ray of phosphorus atoms, which were released when outer-shell electrons were transferred into voids generated as a result of the excitation of the inner-shell electrons of phosphorus atoms by irradiation of the sheet with X-ray, was measured, so as to obtain the concentration of phosphorus atoms. Besides, a filter, in which the amount of phosphorus introduced was known, was produced, and as in the case of the ultrafine cellulose fiber sheet, X-ray fluorescence analysis was performed on it, and a calibration curve was then produced based on the characteristic X-ray intensity of the phosphorus atom and the amount of phosphorus introduced. Thereafter, the phosphorus atom concentration of an ultrafine cellulose fiber sheet, to which an organic counterion was not added, and which were used as a reference value, was subtracted from the phosphorus atom concentration calculated from the calibration curve, to obtain an organic counterion-derived phosphorus atom concentration, so that the content of the organic counterion was calculated.

In the tables below, the thus calculated content of the organic counterion with respect to the sheet is shown.

(3) Density

An ultrafine cellulose fiber sheet cut into a 100-mm square was subjected to humidity control under conditions of a temperature of 23°C and a relative humidity of 50% for 24 hours, and the weight thereof was then measured to calculate a basis weight (g/$m^2$). Further, the obtained value was divided by the thickness of the ultrafine cellulose fiber sheet to calculate the density of the ultrafine cellulose fiber sheet.

< Wrinkles and/or cracks >

When an ultrafine cellulose fiber suspension was processed into a sheet, a total of 81 squares (9 squares in depth x 9 squares in width) were written on the back of an acrylic plate, such that they could fit to the size of a damming metallic mold with a 180-mm square. The ultrafine cellulose fiber sheet, which was attached to the acrylic plate, was observed from above, and squares, in which wrinkles and/or cracks were generated on the ultrafine cellulose fiber sheet, were counted. The sheet, in which the number of squares in which wrinkles and/or cracks were generated was less than 20% of the total square number, was evaluated as ○, and the sheet, in which it was 20% or more, was evaluated as x.

(5) Total light transmittance

Total light transmittance was measured using a hazemeter ("HM-150" manufactured by MURAKAMI COLOR RESEARCH LABORATORY CO., Ltd.), in accordance with JIS K7361.

(6) Haze

Haze was measured using a hazemeter ("HM-150" manufactured by MURAKAMI COLOR RESEARCH LABORATORY CO., Ltd.), in accordance with JIS K7136.

(7) Tensile characteristics

Tensile strength and elastic modulus in tension at a temperature of 23°C and at a relative humidity of 50% were measured using a tension testing machine ("Tensilon" manufactured by A & D Company, Limited), in accordance with JIS K7127.

(8) Yellowness before and after heating

The yellowness (YI) before and after heating the sheet was measured in accordance with JIS K7373, using a colorimeter (Colour Cute i, manufactured by Suga Test Instruments Co., Ltd.). In addition, a difference in the YI values before and after heating was evaluated as ΔYI. Besides, heating conditions consisted of 200°C, 4 hours, and vacuum drying.

(9) Pencil hardness

Pencil hardness was measured in accordance with JIS K5600, with the exception that the load applied to a sample was set at 500 g.

(10) Molding followability

An ultrafine cellulose fiber sheet was cut into a 150-mm square, and a cylindrical molded body made of wood, having a diameter of 50 mm and a height of 60 mm, was entirely wrapped with the aforementioned cut sheet. Subsequently, the cylindrical molded body was observed from above by eyes, and was evaluated in accordance with the following criteria.

○: No voids are found between the cylindrical molded body and the ultrafine cellulose fiber sheet, and no cracks are found on the ultrafine cellulose fiber sheet.
Δ: Voids are found between the cylindrical molded body and the ultrafine cellulose fiber sheet, but no cracks are found on the ultrafine cellulose fiber sheet.
x: Voids are found between the cylindrical molded body and the ultrafine cellulose fiber sheet, and also, cracks are found on the ultrafine cellulose fiber sheet.

Among the targets evaluated as ○ according to the above-described criteria, those, in which almost no wrinkles are found in the wrapping sheet thereof, are particularly evaluated as ◎ .

[Results]

The evaluation results are shown in the tables below.

As is apparent from the following tables, according to the configuration of the present invention, an ultrafine fiber-containing sheet, in which wrinkles and/or cracks generated upon sheet formation are suppressed, can be provided.

Also, as is apparent from the following tables, in Experimental Examples 1 to 7 involving the removal of the organic counterion, the sheet density was improved, and as a result, the elastic modulus in tension was improved. Moreover, as a result, the tensile strength was also improved. Furthermore, in Experimental Examples 1 to 7 involving the removal of the organic counterion after completion of the sheet formation, since the organic counterion as a cause of heat coloration was removed, the values of YI and ΔYI were also reduced after completion of the heating.

As is apparent from the following tables, in Experimental Examples 8 to 12 involving the addition of an organic counterion, a sheet with flexibility, having a small elastic modulus in tension and a small pencil hardness, could be obtained. In addition, the molding followability was also favorable, and thus, it was suggested that the sheets of Experimental Examples 8 to 12 have high practicability as wrapping materials. In contrast, the sheet of Experimental Example 13 had good flexibility and good molding followability, but it had a high ΔYI value by heating, and thus, it was suggested that this sheet should be problematic in terms of practical use.

[Table 1]

| | | Experimental Example 1 | Experimental Example 2 | Experimental Example 3 | Experimental Example 4 | Experimental Example 5 | Experimental Example 6 | Experimental Example 7 |
|---|---|---|---|---|---|---|---|---|
| Ionic substituent | | Phosphoric acid-derived group | Phosphoric acid-derived group | Phosphoric acid-derived group | Phosphoric acid-derived group | Phosphoric acid-derived group | Phosphoric acid-derived group | Carboxy lic acid-derived group |
| Counterion | | Tetrabutyl ammonium ion | Tetrabutyl ammonium ion | Tetrabutyl ammonium ion | Tetraethyl ammonium ion | Tetrabutyl phosphonium ion | Lauryltrimethyl ammonium ion | Tetrabutyl ammonium ion |
| Timing of introduction of counterion | | Before defibration | After defibration | After defibration | After defibration | After defibration | After defibration | Before defibration |
| Method of removing counterion | | Dephosphorylation | Dephosphorylation | Counterion exchange | Dephosphorylation | Dephosphorylation | Dephosphorylation | Counterion exchange |
| Ionic substituent content | (mmol/g) | 0.01 | 0.01 | 1.4 | 0.01 | 0.01 | 0.01 | 1.4 |
| Counterion content | (mmol/g) | 0.01 | 0.01 | 0.09 | 0.01 | 0.01 | 0.01 | 0.09 |
| Wrinkles, cracks | - | ○ | ○ | ○ | ○ | ○ | ○ | ○ |
| Sheet density | ($g/cm^3$) | 1.57 | 1.50 | 1.41 | 1.57 | 1.55 | 1.55 | 1.31 |
| Total light transmittance | (%) | 90.6 | 91.9 | 91.9 | 88.5 | 88.0 | 88.0 | 91.1 |
| Haze | (%) | 0.6 | 20.0 | 20.0 | 26.0 | 33.3 | 33.5 | 1.4 |
| Tensile strength | (MPa) | 135.4 | 138.8 | 63.4 | 156.5 | 140.3 | 135.5 | 74.2 |
| Elastic modulus in tension | (GPa) | 7.0 | 7.0 | 4.5 | 6.8 | 6.8 | 6.5 | 6.4 |
| YI before heating | - | 2.8 | 2.8 | 2.0 | 6.0 | 5.0 | 5.0 | 1.8 |
| YI after heating | - | 7.1 | 6.8 | 52.2 | 8.9 | 7.4 | 9.0 | 76.5 |

(continued)

| | | Experimental Example 1 | Experimental Example 2 | Experimental Example 3 | Experimental Example 4 | Experimental Example 5 | Experimental Example 6 | Experimental Example 7 |
|---|---|---|---|---|---|---|---|---|
| ΔYI | - | 4.3 | 4.0 | 50.1 | 3.0 | 2.4 | 4.0 | 74.7 |
| Pencil hardness | - | - | - | - | - | 2H | 2H | - |
| Molding followability | - | - | - | - | - | Δ | Δ | - |

[Table 2]

| | | Experimental Example 8 | Experimental Example 9 | Experimental Example 10 | Experimental Example 11 | Experimental Example 12 | Experimental Example 13 | Experimental Example 14 | Experimental Example 15 |
|---|---|---|---|---|---|---|---|---|---|
| Ionic substituent | | Phosphoric acid-derived group | Phosphoric acid-derived group | Phosphoric acid-derived group | Phosphoric acid-derived group | Phosphoric acid-derived group | Carboxylic acid-derived group | Phosphoric acid-derived group | Phosphoric acid-derived group |
| Counterion | | Tetrabutyl ammonium ion | Tetrabutyl ammonium ion | Tetraethyl ammonium ion | Tetrabutyl phosphonium ion | Lauryltrimethyl ammonium ion | Tetrabutyl ammonium ion | - | - |
| Timing of introduction of counterion | | Before defibration | After defibration | After defibration | After defibration | After defibration | Before defibration | - | - |
| Method of removing counterion | | - | - | - | - | - | - | - | - |
| Ionic substituent content | (mmol/g) | 1.4 | 1.4 | 1.4 | 1.4 | 1.4 | 1.4 | 1.4 | 1.4 |
| Counterion content | (mmol/g) | 0.41 | 1.10 | 1.25 | 1.08 | 1.12 | 1.10 | - | - |
| Wrinkles, cracks | - | ○ | ○ | ○ | ○ | ○ | ○ | ○ | X |

(continued)

| | | Experimental Example 8 | Experimental Example 9 | Experimental Example 10 | Experimental Example 11 | Experimental Example 12 | Experimental Example 13 | Experimental Example 14 | Experimental Example 15 |
|---|---|---|---|---|---|---|---|---|---|
| Sheet density | ($g/cm^3$) | 1.36 | 1.27 | 1.46 | 1.32 | 1.31 | 1.31 | 1.52 | Failed to form sheet |
| Total light transmittance | (%) | 91.7 | 90.7 | 90.3 | 90.1 | 89.5 | 88.6 | 90.2 | |
| Haze | (%) | 0.6 | 24.1 | 20.7 | 29.1 | 55.9 | 0.8 | 1.0 | |
| Tensile strength | (MPa) | 30.4 | 25.4 | 62.4 | 32.0 | 11.6 | 37.3 | - | |
| Elastic modulus in tension | (GPa) | 1.6 | 0.6 | 2.6 | 1.7 | 2.2 | 3.3 | 6.0 | |
| YI before heating | - | 2.6 | 3.9 | 2.7 | 2.9 | 2.0 | 17.5 | 1.8 | |
| YI after heating | - | 48.3 | 54.4 | 10.4 | 22.6 | 50.0 | 96.2 | 28.3 | |
| ΔYI | - | 45.7 | 50.5 | 7.7 | 19.6 | 48.0 | 78.6 | 26.5 | |
| Pencil hardness | - | 6B | 6B or less | B | 6B | B | 6B | H | |
| Molding followability | - | ◎ | ◎ | ◎ | ◎ | ◎ | ◎ | ○ | |

< Production Example 1 of Laminate >

Using the sheet obtained in any of Experimental Examples 1 to 7, a laminate was obtained by the following procedures.

The sheet was coated with a film of aluminum oxide, using SUNALE R-100B (Picosun). Trimethylaluminum (TMA) was used as an aluminum raw material, and $H_2O$ was used for oxidation of TMA. The chamber temperature was set at 150°C, the pulse time of TMA was set at 0.1 second, and the purge time was set at 4 seconds. Also, the pulse time of $H_2O$ was set at 0.1 second, and the purge time was set at 4 seconds. This cycle was repeated 405 times to obtain a laminate, in which an aluminum oxide film with a film thickness of 30 nm was laminated on both sides of the sheet.

< Production Example 2 of Laminate >

Using the sheet obtained in any of Experimental Examples 1 to 7, a laminate was obtained by the following procedures.

10 Parts by weight of a silsesquioxane-based resin ("COMPOCERAN SQ107" manufactured by Arakawa Chemical Industries, Ltd.), 30 parts by weight of a hardener ("HBSQ202" manufactured by Arakawa Chemical Industries, Ltd.), and 60 parts by weight of isopropylalcohol were mixed with one another to obtain a coating solution. Subsequently, the coating solution was applied on one surface of a base material, using a Meyer bar. Thereafter, the base material was dried at 100°C for 3 minutes, and was then irradiated with 300 mJ/cm$^2$ ultraviolet ray, using a UV conveyer device ("ECS-4011GX" manufactured by Eye Graphics Co., Ltd.) to harden the coating solution, so as to form a resin layer with a thickness of 5 μm on one surface of the base material. Further, also on the opposite surface, a resin layer with a thickness of 5 μm was formed by the same procedures as those described above.

< Production Example 3 of Laminate >

Using the sheet obtained in any of Experimental Examples 1 to 7 or the laminate obtained in Production Example 1 of Laminate, a laminate was obtained by the following procedures.

50 Parts by weight of a urethane acrylate resin composition ("BEAMSET 575CB" manufactured by Arakawa Chemical Industries, Ltd.) was mixed with 50 parts by weight of methylethylketone to obtain a curable resin precursor solution. Thereafter, the above-described curable resin precursor solution was applied on the sheet, using a Meyer bar. Subsequently, the sheet was dried at 80°C for 3 minutes, and was then irradiated with 300 mJ/cm$^2$ ultraviolet ray, using a UV conveyer device ("ECS-4011GX" manufactured by Eye Graphics Co., Ltd.) to harden the curable resin precursor solution, so as to form a resin layer with a thickness of 5 μm on one surface of the sheet. Further, also on the opposite surface, a resin layer with a thickness of 5 μm was formed by the same procedures as those described above, so as to obtain a sheet, in which the resin layer was laminated on both surfaces on which an aluminum oxide film had been laminated.

< Production Example 4 of Laminate >

Using the sheet obtained in any of Experimental Examples 1 to 7 or the laminate obtained in Production Example 2 of Laminate, a laminate was obtained by the following procedures.

The sheet was coated with a silicon oxynitride film, using an ICP-CVD roll to roll device (manufactured by SELVAC CORPORATION). A resin laminate sheet was attached to the upper surface of a carrier film (PET film) using a double sided tape, and it was then placed in a vacuum chamber. The temperature in the vacuum chamber was set at 50°C, and silane, ammonia, oxygen and nitrogen were used as inlet gas. Film formation was carried out for 45 minutes by plasma discharge, so as to obtain a sheet, in which a silicon oxynitride film with a film thickness of 500 nm was laminated on one surface of the resin laminate sheet. Further, also on the opposite surface, a film was formed by the same procedures as those described above, so as to obtain a sheet, in which a silicon oxynitride film with a film thickness of 500 nm was laminated on both surfaces thereof.

< Production Example 5 of Laminate >

Using the sheet obtained in any of Experimental Examples 8 to 12, a laminate was obtained by the following procedures.

The sheet was coated with a film of aluminum oxide, using SUNALE R-100B (Picosun). Trimethylaluminum (TMA) was used as an aluminum raw material, and $H_2O$ was used for oxidation of TMA. The chamber temperature was set at 150°C, the pulse time of TMA was set at 0.1 second, and the purge time was set at 4 seconds. Also, the pulse time of $H_2O$ was set at 0.1 second, and the purge time was set at 4 seconds. This cycle was repeated 405 times to

obtain a laminate, in which an aluminum oxide film with a film thickness of 30 nm was laminated on both sides of the sheet.

< Production Example 6 of Laminate >

Using the sheet obtained in any of Experimental Examples 8 to 12, a laminate was obtained by the following procedures.

10 Parts by weight of a silsesquioxane-based resin ("COMPOCERAN SQ107" manufactured by Arakawa Chemical Industries, Ltd.), 30 parts by weight of a hardener ("HBSQ202" manufactured by Arakawa Chemical Industries, Ltd.), and 60 parts by weight of isopropylalcohol were mixed with one another to obtain a coating solution. Subsequently, the coating solution was applied on one surface of a base material, using a Meyer bar. Thereafter, the base material was dried at 100°C for 3 minutes, and was then irradiated with 300 mJ/cm$^2$ ultraviolet ray, using a UV conveyer device ("ECS-4011GX" manufactured by Eye Graphics Co., Ltd.) to harden the coating solution, so as to form a resin layer with a thickness of 5 μm on one surface of the base material. Further, also on the opposite surface, a resin layer with a thickness of 5 μm was formed by the same procedures as those described above.

< Production Example 7 of Laminate >

Using the sheet obtained in any of Experimental Examples 8 to 12 or the laminate obtained in Production Example 5 of Laminate, a laminate was obtained by the following procedures.

50 Parts by weight of a urethane acrylate resin composition ("BEAMSET 575CB" manufactured by Arakawa Chemical Industries, Ltd.) was mixed with 50 parts by weight of methylethylketone to obtain a curable resin precursor solution. Thereafter, the above-described curable resin precursor solution was applied on the sheet, using a Meyer bar. Subsequently, the sheet was dried at 80°C for 3 minutes, and was then irradiated with 300 mJ/cm$^2$ ultraviolet ray, using a UV conveyer device ("ECS-4011GX" manufactured by Eye Graphics Co., Ltd.) to harden the curable resin precursor solution, so as to form a resin layer with a thickness of 5 μm on one surface of the sheet. Further, also on the opposite surface, a resin layer with a thickness of 5 μm was formed by the same procedures as those described above, so as to obtain a sheet, in which the resin layer was laminated on both surfaces on which an aluminum oxide film had been laminated.

< Production Example 8 of Laminate >

Using the sheet obtained in any of Experimental Examples 8 to 12 or the laminate obtained in Production Example 6 of Laminate, a laminate was obtained by the following procedures.

The sheet was coated with a silicon oxynitride film, using an ICP-CVD roll to roll device (manufactured by SELVAC CORPORATION). A resin laminate sheet was attached to the upper surface of a carrier film (PET film) using a double sided tape, and it was then placed in a vacuum chamber. The temperature in the vacuum chamber was set at 50°C, and silane, ammonia, oxygen and nitrogen were used as inlet gas. Film formation was carried out for 45 minutes by plasma discharge, so as to obtain a sheet, in which a silicon oxynitride film with a film thickness of 500 nm was laminated on one surface of the resin laminate sheet. Further, also on the opposite surface, a film was formed by the same procedures as those described above, so as to obtain a sheet, in which a silicon oxynitride film with a film thickness of 500 nm was laminated on both surfaces thereof.

## Claims

1. A sheet comprising
ultrafine fibers having an ionic substituent being at least one selected from the group consisting of a phosphoric acid-derived group, a carboxylic acid-derived group, and a sulfuric acid-derived group,
wherein the amount of ionic substituents is from 0.001 to 5.0 mmol/g,
wherein the ultrafine fibers are fibers having a fiber width of 1000 nm or less, and an organic ion that is a counterion of the ionic substituent, wherein
the content of the organic ion is 0.40 mmol/g or less.

2. The sheet according to claim 1, which has a haze of 40% or less.

3. The sheet according to claim 1 or 2, which has a density of 1.0 g/cm$^3$ or more.

4. The sheet according to any one of claims 1 to 3, wherein the organic ion contains 4 or more carbon atoms.

5. The sheet according to any one of claims 1 to 4, wherein the content of the ionic substituent is 0.5 mmol/g or less based on the ultrafine fibers.

6. The sheet according to any one of claims 1 to 5, which has an elastic modulus in tension of 4.0 GPa or more at a temperature of 23°C at a relative humidity of 50%.

7. A laminate comprising
the sheet according to any one of claims 1 to 6, and
at least one of an inorganic layer and an organic layer formed at least one side of the sheet.

## Patentansprüche

1. Eine Folie, umfassend
ultrafeine Fasern mit einem ionischen Substituenten, der mindestens einer ist, ausgewählt aus der Gruppe bestehend aus einer von Phosphorsäure abgeleiteten Gruppe, einer von Carbonsäure abgeleiteten Gruppe und einer von Schwefelsäure abgeleiteten Gruppe,
wobei die Menge der ionischen Substituenten von 0,001 bis 5,0 mmol/g beträgt, wobei die ultrafeinen Fasern Fasern mit einer Faserbreite von 1000 nm oder weniger sind, und
ein organisches Ion, das ein Gegenion des ionischen Substituenten ist, wobei
der Gehalt des organischen Ions 0,40 mmol/g oder weniger beträgt.

2. Die Folie gemäß Anspruch 1, das eine Trübung von 40 % oder weniger aufweist.

3. Die Folie gemäß Anspruch 1 oder 2, die eine Dichte von 1,0 g/cm$^3$ oder mehr aufweist.

4. Die Folie gemäß einem der Ansprüche 1 bis 3, wobei das organische Ion 4 oder mehr Kohlenstoffatome enthält.

5. Die Folie gemäß einem der Ansprüche 1 bis 4, wobei der Gehalt des ionischen Substituenten 0,5 mmol/g oder weniger bezogen auf die ultrafeinen Fasern beträgt.

6. Die Folie gemäß einem der Ansprüche 1 bis 5, das einen Spannungsetastizitätsmodul von 4,0 GPa oder mehr bei einer Temperatur von 23°C und einer relativen Feuchtigkeit von 50% aufweist.

7. Ein Laminat, umfassend
die Folie gemäß einem der Ansprüche 1 bis 6, und
mindestens eine von einer anorganischen Schicht und einer organischen Schicht, die auf mindestens einer Seite der Folie ausgebildet sind.

## Revendications

1. Feuille comprenant
des fibres ultrafines présentant un substituant ionique étant au moins l’un sélectionné à partir du groupe consistant en un groupe dérivé de l’acide phosphorique, un groupe dérivé de l’acide carboxylique et un groupe dérivé de l’acide sulfurique,
dans laquelle la quantité de substituants ioniques est de 0,001 à 5,0 mmol/g,
dans laquelle les fibres ultrafines sont des fibres présentant une largeur de fibre de 1 000 nm ou moins, et
un ion organique qui est un contre-ion du substituant ionique, dans laquelle
la teneur en ion organique est de 0,40 mmol/g ou moins.

2. Feuille selon la revendication 1, qui présente un voilage de 40 % ou moins.

3. Feuille selon la revendication 1 ou 2, qui présente une densité de 1,0 g/cm$^3$ ou plus.

4. Feuille selon l’une quelconque des revendications 1 à 3, dans laquelle l’ion organique contient 4 atomes de carbone ou plus.

5. Feuille selon l'une quelconque des revendications 1 à 4, dans laquelle la teneur en substituant ionique est de 0,5 mmol/g ou moins sur la base des fibres ultrafines.

6. Feuille selon l'une quelconque des revendications 1 à 5, qui présente un module élastique en traction de 4,0 GPa ou plus à une température de 23 °C à une humidité relative de 50 %

7. Stratifié comprenant
la feuille selon l'une quelconque des revendications 1 à 6, et
au moins une d'une couche inorganique et d'une couche organique formée sur au moins un côté de la feuille.

[Fig. 1]

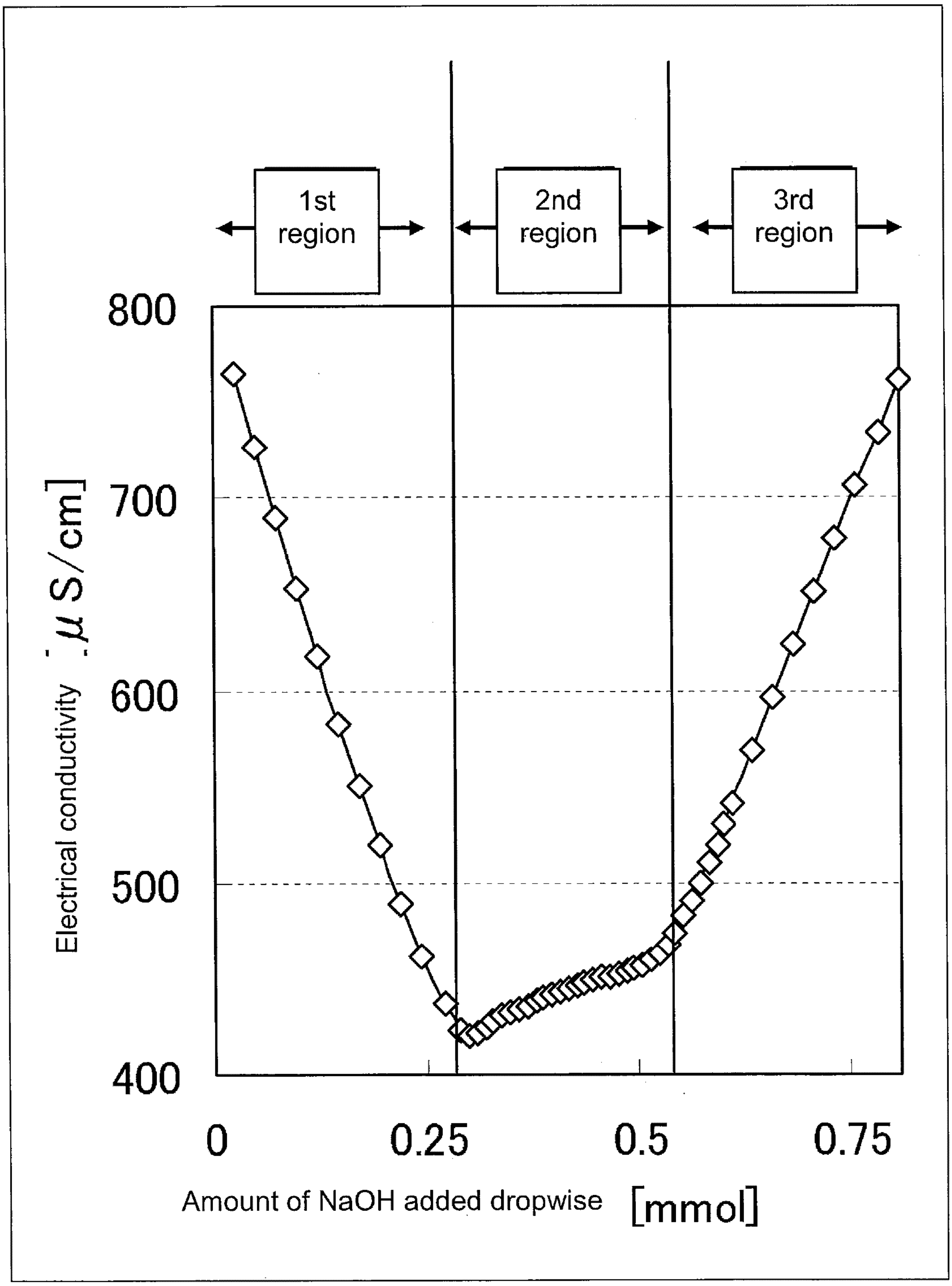
1st region
2nd region
3rd region
800
700
600
500
400
Electrical conductivity [μS/cm]
0
0.25
0.5
0.75
Amount of NaOH added dropwise [mmol]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008308802 A
- JP 2010254726 A
- JP 2012511596 A
- WO 2013073652 A
- JP 2012021081 A
- WO 2011111612 A
- JP 2013253200 A


### Non-patent literature cited in the description


- **SAITO.** *Biomacromolecules,* 2007, vol. 8, 2485-2491